(19) Europäisches Patentamt
European Patent Office
Office européen des brevets

(11) **EP 4 367 558 B1**

(12) **EUROPÄISCHE PATENTSCHRIFT**

(45) Veröffentlichungstag und Bekanntmachung des Hinweises auf die Patenterteilung:
**29.10.2025 Patentblatt 2025/44**

(21) Anmeldenummer: **22746975.6**

(22) Anmeldetag: **04.07.2022**

(51) Internationale Patentklassifikation (IPC):
**G03F 7/00** (2006.01)   **G02B 27/09** (2006.01)
**G02B 27/10** (2006.01)

(52) Gemeinsame Patentklassifikation (CPC):
**G02B 27/1093; G02B 27/0905; G02B 27/0927; G02B 27/0944; G03F 7/70408**

(86) Internationale Anmeldenummer:
**PCT/EP2022/068490**

(87) Internationale Veröffentlichungsnummer:
**WO 2023/280793 (12.01.2023 Gazette 2023/02)**

(54) **VORRICHTUNG UND VERFAHREN ZUR LASERINTERFERENZSTRUKTURIERUNG VON SUBSTRATEN MIT PERIODISCHEN PUNKTSTRUKTUREN FÜR ANTIREFLEXIONSEIGENSCHAFTEN**

APPARATUS AND METHOD FOR THE LASER-INTERFERENCE PATTERNING OF SUBSTRATES WITH PERIODIC DOT PATTERNS FOR ANTIREFLECTIVE PROPERTIES

DISPOSITIF ET PROCÉDÉ DE STRUCTURATION PAR INTERFÉRENCE LASER DE SUBSTRATS AFIN DE LES DOTER DE STRUCTURES PONCTUELLES PÉRIODIQUES LEUR CONFÉRANT DES PROPRIÉTÉS ANTIREFLET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.07.2021 DE 102021117204**
**31.03.2022 LU 102920**

(43) Veröffentlichungstag der Anmeldung:
**15.05.2024 Patentblatt 2024/20**

(73) Patentinhaber: **Fusion Bionic GmbH**
**01159 Dresden (DE)**

(72) Erfinder:
• **KUNZE, Tim**
**01159 Dresden (DE)**
• **ALAMRI, Sabri**
**01159 Dresden (DE)**

(74) Vertreter: **Gruner, Leopold Joachim**
**White ip | Patent & Legal GmbH**
**Königstraße 7**
**01097 Dresden (DE)**

(56) Entgegenhaltungen:
EP-B1- 2 596 899     US-A1- 2001 035 991
US-A1- 2004 227 927     US-A1- 2006 046 156
US-A1- 2012 081 687

• LASAGNI ANDRÉS ET AL: "High speed surface functionalization using direct laser interference patterning, towards 1 m/min fabrication speed with sub-μm resolution", PROCEEDINGS OF SPIE, IEEE, US, vol. 8968, 6 March 2014 (2014-03-06), pages 89680A - 89680A, XP060034456, ISBN: 978-1-62841-730-2, DOI: 10.1117/12.2041215
• ZHOU Y ET AL: "ARTICLES YOU MAY BE INTERESTED IN Fabrication of large-area 3D optical fishnet metamaterial by laser interference lithography", APPL. PHYS. LETT. APPL. PHYS. LETT. PHYSICS LETTERS, 30 September 2013 (2013-09-30), XP093021250, Retrieved from the Internet <URL:https://aip.scitation.org/doi/pdf/10.1063/1.4821508> [retrieved on 20230206]

**Beschreibung**

**Technisches Gebiet**

Die vorliegende Erfindung betrifft den Bereich der Strukturierung von Substraten, insbesondere eine Vorrichtung und ein Verfahren zur Strukturierung von Oberflächen und dem Inneren eines transparenten Substrats mittels Laserinterferenzstrukturierung. Zudem betrifft die vorliegende Erfindung ein strukturiertes Substrat - beispielhaft sind hier flächige Substrate, insbesondere sog. Antireflexionsverglasung genannt - mit Antireflexionseigenschaften, das eine periodische Punktstruktur umfasst.

**Stand der Technik**

Aus dem Stand der Technik sind Verfahren zur Behandlung von Oberflächen bekannt, mit denen die Oberfläche von transparenten Substraten, insbesondere Glas, aber auch festen Polymeren, so verändert werden kann, dass die Reflexion des Substrates verringert werden kann. Typische Verfahren bringen hierzu ein zusätzliches Material auf die Oberfläche des zu entspiegelnden Substrats auf (sog. Struktur- oder Schicht-aufbauende Verfahren), wobei sich der Brechungsindex der verschiedenen Materialien unterscheidet.

In US 8,557,877 B2 wird beispielsweise ein mögliches Schicht-aufbauendes Verfahren erläutert. Dabei wird eine Beschichtungslösung aus mindestens zwei chemischen Ausgangsmaterialien erzeugt, anschließend deren pH-Wert reduziert und dann optional mit einer weiteren Lösung verdünnt, bevor die Beschichtung auf das gewünschte Substrat aufgetragen wird. Bei dieser Art von Beschichtungsverfahren werden verschiedene chemische Substanzen mit oftmals geringer Umweltverträglichkeit verwendet, deren Entsorgung und Handling kostenintensiv und aufwändig ist.

Dieser Art von Verfahren liegt eine Verminderung des Reflexionsgrades durch destruktive Interferenz zugrunde. Dabei muss der Brechungsindex des Materials, das für die Beschichtung verwendet wird, auf das zu beschichtende Substrat und das Medium, das sich vor dem Substrat befindet (in der Regel Luft), abgestimmt werden. Da nicht jedes Beschichtungsmaterial auf die gleiche Weise verarbeitet werden kann, ist es nach einem solchen Verfahren erforderlich, unterschiedliche Prozesse für die Beschichtung unterschiedlicher Substratmaterialien zu verwenden.

In US 10,459,125 B2 wird daher ein Verfahren beschrieben, bei dem auf einem Substrat eine sog. Mottenaugenstruktur chemisch generiert wird, indem auf das Substrat ein Polymerfilm aufgetragen wird. Diese Art von Struktur ist dem Prinzip des Mottenauges nachempfunden, auf dessen Oberfläche sich regelmäßig angeordnete Nanostrukturen finden, deren Dimensionen kleiner sind als die Wellenlänge des auf sie eintreffenden Lichts. Dadurch wird eine Schicht mit abgestuftem Brechungsindex am Übergang vom Medium, das sich vor dem Substrat befindet, und dem Substrat selbst erzeugt, welche die Reflexion erheblich vermindert.

Ein so erzeugter Film kann unabhängig vom zu beschichtenden Substrat verwendet werden, da die Reduktion der Reflexion nicht vom Brechungsindex des Materials, das für die Beschichtung verwendet wird, abhängt. Allerdings basiert die Beschichtungsmethode nach wie vor auf chemischen Substanzen mit den oben bereits genannten Nachteilen.

Zusätzlich ist eine so erzeugte Beschichtung anfällig für mechanische Beanspruchung (Abrieb, Stöße, etc.) und altert dementsprechend schnell. Nach einiger Zeit löst sich die Beschichtung daher häufig vom Substrat und/oder verliert ihre reflexionsvermindernden Eigenschaften.

In WO 2019/166836 A1 wird ein Verfahren zur Herstellung einer Antireflexionsstruktur erläutert, bei dem mittels eines Lasers die Oberfläche eines Substrates in der Form bearbeitet wird, dass sie Antireflexionseigenschaften erhält. Hierbei wird mit einem fokussierten Laserstrahl das Substratmaterial modifiziert und dadurch eine Nanostruktur durch Selbstorganisationsprozesse unter Ausnutzen von laser-induzierten periodischen Oberflächenstrukturen (engl. Laser-induced Periodic Surface Structures - LIPSS) erzeugt. Durch die geeignete Auswahl von Laserfluenz und Überlagerung der Strahlbrennpunkte auf der Substratoberfläche kann eine sich quasi-periodisch wiederholende Strukturierung generiert werden. Somit erhält man eine Antireflexionsoberfläche. Es werden keine Chemikalien benötigt und eine große Bandbreite von Substratmaterialien kann auf diese Weise bearbeitet werden.

Dieses Verfahren arbeitet jedoch sukzessiv und ist bedingt durch den zugrundeliegenden Selbstorganisationsprozess der LIPSS zeitaufwändig. Eine flächige Nanostrukturerzeugung in einem Schritt ist nicht möglich, da die LIPSS sich nur durch wiederholtes Bearbeiten nahe liegender Flächenbereiche ausprägen. Außerdem hängt die Regelmäßigkeit der Struktur von den konkreten Prozess- bzw. Umgebungsbedingungen ab, so dass Abweichungen im Oberflächenzustand (Material leicht unterschiedlich, mikroskopische Verschmutzungen) zu veränderten Ergebnissen führen kann.

In EP 2 431 120 A1 wird ein Verfahren zur direkten Strukturierung eines dünnen Films offenbart, bei dem mittels interferierender Laserstrahlen periodische Strukturen in dünnen Metallfilmen erzeugt werden können. Hierbei werden mehrere gepulste Laserstrahlen auf den dünnen Film gelenkt, wobei diese in einem Interferenzbereich interferieren, sodass in den Bereichen hoher Intensität das Material des dünnen Films verdampft wird. Das Verfahren ist dadurch gekennzeichnet, dass die so entstehende Struktur durch die Einstellung der Intensität der Laserstrahlen oder der Verschiebung des Films in z-Richtung (also in Richtung der einfallenden Laserstrahlen oder von ihnen weg) verändert werden kann. Über zusätzliche optische Elemente wird ein Phasenunterschied zwischen den Laserstrahlen erzeugt, die das Interferenzmuster beeinflussen. Die einfallenden Laserstrahlen werden durch ein Fokussierelement auf die Oberfläche des dünnen Films fokussiert und dabei verkleinert, sodass sich Bereiche hoher Intensität ergeben, in denen das Material des dünnen Films verdampft wird.

Dieses Verfahren benötigt eine Möglichkeit, die Intensität der einfallenden Laserstrahlen zu modifizieren. Dies kann entweder über die Festlegung auf eine bestimmte Laserstrahlungsquelle oder eine Einheit zur Kontrolle der Intensität des Laserstrahls geschehen. Die Intensität muss abhängig von der Verdampfungsschwelle des Materials des dünnen Films eingestellt werden. Dies bedeutet, dass für unterschiedliche Materialien unterschiedliche Laserstrahlungsquellen verwendet werden müssen, oder ein zusätzliches Element zur Intensitätskontrolle benötigt wird. Eine Verschiebung der optischen Elemente ermöglicht keine Kontrolle des entstehenden Interferenzmusters. Bei der Bearbeitung von Materialien mit einer hohen Verdampfungsschwelle ist zudem die Beschädigung der optischen Elemente im Strahlengang des Lasers denkbar.

In der US 2004/0227927 A1 ist eine Interferometervorrichtung offenbart, welches dazu ausgelegt ist, ein Interferenzmuster mit variabler Periodizität in einem Fokussierpunkt zu erzeugen, wobei die Vorrichtung ein bewegliches Strahlteilerelement und einen beweglichen Reflektor umfasst, welche einen einfallenden Strahl in zwei Laserteilstrahlen aufteilen und zumindest einen der Laserteilstrahlen umlenken, wobei durch das Bewegen des Strahlteilerelements und des Reflektors die Periodizität variierbar ist. Das Bewegen des Strahlteilerelements und des Reflektors erfolgt hierbei durch eine motorisierte Plattform.

Diese Vorrichtung umfasst einen komplexen und verschleißanfälligen Aufbau, da die Strahlformung zum Beeinflussen der Periodizität des erzeugten Interferenzmusters lediglich durch das Verschieben zweier optischer Elemente, nämlich des Strahlteilerelements und des Reflektors, realisierbar ist. Darüber hinaus ist der Abstand zwischen dem Strahlteilerelement und dem Reflektor fix und deren Anordnung auf einer motorisierten Plattform platzintensiv.

Aus wissenschaftlichen Publikationen ("Microfabrication and Surface Functionalization of Soda Lime Glass through Direct Laser Interference Patterning", Soldera et al., Nanomaterials 2021) sind Verfahren zur direkten Laserinterferenzstrukturierung bekannt. Allerdings benötigen diese Verfahren zum Kontrollieren der erzeugten Strukturen einen aufwändigen Umbau und eine Neuausrichtung von mehr als einem optischen Element im Strahlengang. Bei industrieller Anwendung mit einem hohen Durchsatz an zu strukturierenden Substraten mit unterschiedlichen Ansprüchen an die gewünschten Strukturweiten erfordert dies ein regelmäßiges Bewegen und Justieren der optischen Elemente im Strahlengang, wodurch der Prozess zum einen weniger flexibel ist, und zum anderen die optischen Elemente bei jeder Anwendung, in Folge der jeweilig neuen Justierung der optischen Elemente, einem größeren Verschleiß und einer Beschädigungsgefahr ausgesetzt sind.

Darüber hinaus sind die durch direkte Laserinterferenzstrukturierung erzeugbaren minimalen Strukturabmessungen auf den Mikrometerbereich beschränkt. Die minimal erzeugbaren Abmessungen, die den Veröffentlichungen zu entnehmen sind, liegen in einem Bereich welcher teilweise deutlich größer ist als die Wellenlänge von Strahlung aus dem sichtbaren Spektrum. Eine so erzeugte Antireflexionsstruktur weist möglicherweise unerwünschte Beugungsmuster für besonders kurzwelliges Licht auf und eignet sich nicht zum Unterbinden der Reflexion in diesen Wellenlängenbereichen, bzw. zum Sicherstellen der Transmission, einfallender Lichtstrahlen aus dem kompletten Spektrum des sichtbaren Lichts.

Eine weitere Publikation ("Improving throughput and microstructure uniformity in Direct Laser Interference Patterning utilizing top-hat shaped beams", El-Khoury et al., Research Square 2021) offenbart die Verwendung von Laserstrahlen mit Gauß- und Top-Hat Profilen in einem optischen Aufbau zum Erzeugen eines Interferenzmusters auf einem Substrat, wobei der optische Aufbau eine Laserstrahlungsquelle, ein erstes Umlenkelement, ein Strahlformungselement, ein Strahlteilerelement, ein weiteres Umlenkelement, sowie ein Fokussierelement umfasst. Die Periodizität des Interferenzmusters ist durch das Verschieben der optischen Elemente zueinander einstellbar, insbesondere durch das Verschieben des weiteren Umlenkelements im Strahlengang der Laser(teil)strahlen.

Zum Erzeugen des Interferenzmusters ist hierbei eine Vielzahl an optischen Elementen erforderlich, wodurch ein komplexer und verschleißanfälliger Aufbau notwendig wird. Darüber hinaus sind die erzeugbaren Strukturperioden auf minimal 6,7 $\mu$m begrenzt.

Weiterhin ist ein Verfahren zum Erzeugen hierarchischer Mikrotexturen mittels Laserstrukturierter Stempel bekannt ("Hierarchical Microtextures Embossed on PET from Laser-Patterned Stamps", Bouchard et al., Materials 2021), wobei der Laserstrukturierte Stempel mittels Direct Laser Writing (DLW) und Direct Laser Interference Patterning (DLIP) erzeugt wird. Dabei wurde eine fixe optische Anordnung verwendet, welche eine festgelegte Strukturweite von 3,1 $\mu$m für die Interferenzstrukturierung erzeugt. Die so erzeugte Interferenzstrukturierung mit Abmessungen im niedrigen Mikrometerbereich ist einer Laserstrukturierung überlagert, welche durch Direct Laser Writing erzeugt wird. Dabei wird ein Laserstrahl direkt auf das Material gelenkt, um im Bereich der maximalen Intensität eine Strukturierung des Substrates, insbesondere eine zapfenförmige Strukturierung, vorzunehmen. Dabei beträgt der Durchmesser der Struktur typischerweise etwa 110 $\mu$m, und somit ein Vielfaches der durch Interferenzstrukturierung erzeugten Strukturperioden. Die durch die Überlagerung der beiden Strukturen erzeugte Struktur im Substrat wird als hierarchische Struktur bezeichnet.

Allerdings ist das vorgegebene Verfahren nicht zum Erzeugen einer Antireflexionsbeschichtung auf einem flächigen Substrat geeignet, da der Strukturierungsprozess aus mehreren Prozessschritten besteht (sukzessives Strukturieren zunächst mittels DLW, dann DLIP), und die erzeugbaren minimalen Strukturabmessungen mittels desselben Aufbaus sind auf die angegebenen Abmessungen (3,1 μm) beschränkt. Somit ist die gezeigte Vorrichtung und das dargelegte Verfahren nicht zum Erzeugen einer gleichmäßigen Antireflexionsstrukturierung innerhalb eines Strukturierungsschrittes und mit veränderbaren Strukturweiten, welche für elektromagnetische Wellen im gesamten Spektrum des sichtbaren Lichts Antireflexionseigenschaften aufweisen.

Aus der US 2001/035991 A1 ist ein Interferenzlithographiesystem bekannt, mit dem ein einfallender Laserstrahl in mehr als zwei Abschnitte ("Teilstrahlen") aufgeteilt werden kann, und mit der eine dreidimensionale Oberflächenstruktur in einer dünnen Fotolackschicht erzeugt werden kann, wobei diese Oberflächenstruktur als zylinderförmige oder becherförmige Löcher ausgebildet sein können. Allerdings offenbart die Patentschrift nicht, dass derart strukturierte Substrate Antireflexionseigenschaften aufweisen oder wie derartige Strukturen aufgebaut sein müssen, um Antireflexionseigenschaften zu erzeugen.

Die EP 2 596 899 B1 offenbart eine Vorrichtung und ein Verfahren zur Interferenzstrukturierung von flächigen Proben. Die Vorrichtung umfasst eine Fokussieranordnung, die einen Laserstrahl in das Probenvolumen fokussiert. Der Laserstrahl kann auch in einer weiteren Raumrichtung fokussiert werden, die nicht parallel zur ersten Raumrichtung ist. Die Vorrichtung enthält eine Aufweit- und Auftrennanordnung, die im Strahlengang erst nach der Fokussieranordnung positioniert ist und die den Laserstrahl aufweitet. Teil der Aufweit- und Auftrennanordnung ist dabei nur ein solcher Strahlteiler, der lediglich dazu geeignet ist, einen Laserstrahl in zwei Teilstrahlen aufzuweiten.

**Lösung**

Durch die vorliegende Erfindung werden ein strukturiertes Substrat nach Anspruch 1 und eine Laserinterferenzstrukturierungsvorrichtung nach Anspruch 7 bereitgestellt. Darüber hinaus wird ein Verfahren nach Anspruch 12 bereitgestellt. Die beanspruchte Erfindung bezieht sich auch auf die Verwendung eines strukturierten Substrates nach Anspruch 18.

Weitere vorteilhafte Ausführungen sind der Beschreibung und den Unteransprüchen zu entnehmen.

**Allgemeine Vorteile**

Als Vorteil der hierin definierten Vorrichtung kann genannt werden, dass durch diese Vorrichtung und dem mit ihrer Hilfe realisierbaren Verfahren bei der Strukturierung von Substraten, insbesondere bei der Erzeugung einer Struktur mit Antireflexionseigenschaften auf die Verwendung von Chemikalien und deren aufwändige Entsorgung verzichtet werden kann. Darüber hinaus kann somit auch auf die Aufreinigung der Substrate verzichtet werden.

Des Weiteren können eine breite Anzahl von Substraten, bevorzugt flächigen und/oder transparenten Substraten, insbesondere transparente Materialien mit der Vorrichtung bearbeitet werden. Da das Verfahren nicht vom Brechungsindex oder der Haftung bestimmter Beschichtungsmaterialien auf dem Substrat abhängig ist, ist dieses Verfahren also flexibler als herkömmliche chemische Verfahren.

Im Vergleich zu WO 2019/166836 A1 ist die Bearbeitungszeit nach diesem Verfahren deutlich geringer, da die Periodizität der Strukturen durch die Interferenz der einfallenden, zumindest 3, vorzugsweise zumindest 4 Teilstrahlen in einem Interferenzbereich gewährleistet wird, und nicht durch zeitintensivere Selbstorganisationsprozesse zustande kommt. Zudem ist gegenüber herkömmlichen Verfahren von Vorteil, dass die Form (strukturelle Ausgestaltung; Geometrie) der erzeugten Mikro-/Nanostrukturen kontrolliert werden kann. Durch die Anzahl der interferierenden (Teil-)Strahlen, deren Polarisation, sowie durch die Einstellung der Prozessparameter, können die Strukturen in der Geometrie gesteuert werden und dadurch die Antireflexionseigenschaften gezielt beeinflusst werden.

Ferner ist die Stabilität der so erzeugten periodische Punktstruktur zu erwähnen, die im Vergleich zu herkömmlichen Beschichtungen beständiger ist, da sie sich nicht über die Zeit und die einsatzbedingte Materialbeanspruchung vom zu beschichtenden Substrat lösen kann.

Wird die Strukturierung im Volumen, d.h. im Inneren des Substrats, bevorzugt flächigen und/oder transparenten Substrats, insbesondere in dem transparenten Material vorgenommen, so ist die entstandene Strukturierung (d.h. die periodische Punktstruktur des strukturierten Substrates) unempfindlicher gegen Stöße und Abrieb als herkömmliche Beschichtungen. Die Erfinder haben herausgefunden, dass die Strukturierung (hierin auch als Texturierung bezeichnet) im Inneren des Materials (d.h. unterhalb der Oberfläche) nicht zwingend Antireflexionseigenschaften erzeugt. Die Texturierung im Inneren des Materials ist jedoch für andere Anwendungsgebiete interessant, wie Produktschutz, optische Datenspeicherung, Dekoration, usw.

Von besonderem Vorteil ist, dass durch den hierin offenbarten Aufbau der Vorrichtung bzw. die Anordnung der optischen Komponente Substrate mit sehr hohen Strukturierungsraten von bis zu 0,9 m$^2$/min, insbesondere im Bereich von 0,01 bis 0,9 m$^2$/min, besonders bevorzugt im Bereich von 0,05 bis 0,9 m$^2$/min, ganz besonders bevorzugt im Bereich von 0,1 bis 0,9 m$^2$/min strukturiert werden können. Dies ist dadurch gewährleistet, dass der Bereich, in dem die zumindest drei Teilstrahlen überlagert werden, durch eine bevorzugte Auswahl optischer Elemente aufgeweitet werden kann, wodurch in einem Bearbeitungsschritt eine große Fläche bestrahlt werden kann. Im Gegensatz zu dem, dem Fachmann bekannten Verfahren wie dem direkten Laserschreiben ist keine starke Fokussierung zum Erzeugen von hochauflösenden Merkmalen notwendig.

Ein solcher Aufbau erlaubt vorteilhaft das schnelle Abtasten einer Oberfläche eines Substrats, sodass eine hohe Strukturierungsrate von bis zu 3 m²/min, insbesondere im Bereich von 0,05 bis 2 m²/min, besonders bevorzugt im Bereich von 0,1 bis 1 m²/min, ganz besonders bevorzugt im Bereich von 0,1 bis 0,9 m²/min erreichbar ist. Die genaue Strukturierungsrate ist dabei insbesondere von der verfügbaren Laserleistung abhängig. Mit zukünftigen Technologien, welche eine höhere Laserleistung aufweisen, sind demzufolge noch höhere Strukturierungsraten erreichbar.

## Ausführliche Beschreibung

Die erfindungsgemäße Vorrichtung beschreibt einen Aufbau zur Laserinterferenzstrukturierung von Substraten, bspw. flächigen und/oder transparenten Substraten zur Erzeugung eines strukturierten Substrates, umfassend eine **periodische Punktstruktur** im Mikro- oder Submikrometerbereich, insbesondere zur Herstellung einer sog. Antireflexionsverglasung auf dem Substrat oder im Volumen (d.h. innerhalb) dieses Substrates.

Dabei handelt es sich um eine Laserinterferenzstrukturierungsvorrichtung zur direkten Laserinterferenzstrukturierung eines Substrats - beispielhaft sind hierin flächige und/oder transparente Substrate zu nennen - umfassend

- eine Laserstrahlungsquelle (1) zum Emittieren eines Laserstrahls,

- ein Strahlteilerelement (2), das im Strahlengang (3) des Laserstrahls angeordnet ist,

- ein Fokussierelement (4), das derart eingerichtet ist, dass dieses die Teilstrahlen derart durchlaufen, dass die Teilstrahlen auf der Oberfläche oder im Volumen eines Substrats, bevorzugt flächigen und/oder transparenten Substrats (5) in einem Interferenzbereich interferierbar sind,

wobei der Strahlteiler (2) entlang seiner optischen Achse im Strahlengang (3) frei beweglich ist, und wobei der Strahlteiler (2) dazu eingerichtet ist, den einfallenden Laserstrahl, der von der Laserstrahlungsquelle (1) ausgesandt wird, in zumindest 3 Teilstrahlen, besonders bevorzugt zumindest 4, insbesondere 4 bis 8, also 4, 5, 6, 7, oder 8 Teilstrahlen, aufzuteilen.

Besonders bevorzugt ist der Strahlteiler (2) derart eingerichtet, dass dieser den einfallenden Laserstrahl in ein geradzahliges Vielfaches, d.h. 4, 6 oder 8 Teilstrahlen, ganz besonders bevorzugt 4 Teilstrahlen aufteilt.

Alternativ oder ergänzend hierzu kann ein Strahlteiler (2) derart vorgesehen sein, dass dieser einen ersten Strahlteiler und zumindest einen, dem ersten Strahlteiler nachgeordneten weiteren Strahlteiler umfasst, wobei der erste Strahlteiler den einfallenden Laserstrahl in zumindest 2 Teilstrahlen aufteilt und der weitere Strahlteiler in zumindest einem Strahlengang eines Teilstrahls angeordnet ist und diesen Teilstrahl beim Durchlaufen in zumindest 2 Teilstrahlen aufteilt.

Zur Laserinterferenzstrukturierung des Substrats (5), bevorzugt flächigen und/oder transparenten Substrats, wird hierbei der von der Laserstrahlungsquelle emittierte Laserstrahl durch das Strahlteilerelement (2) in zumindest 3, bevorzugt zumindest 4 Teilstrahlen aufgeteilt. Aus dem Stand der Technik sind lediglich Zweistrahlinterferenzen (d.h. Strukturierung mittels Interferenz von zwei Teilstrahlen) bekannt. Derartige Zweistrahlinterferenzen erzeugen jedoch nur Linienstrukturen auf dem Substrat.

Im Anschluss werden die Teilstrahlen durch das Fokussierelement (4) so umgelenkt, dass sie auf der Oberfläche oder im Inneren eines Substrats (5), bevorzugt flächigen und/oder transparenten Substrats, in einem Interferenzbereich, auch als Interferenzpixel bezeichnet, interferieren.

Dadurch kann eine zweidimensionale, periodische Punktstruktur mit Abmessungen im Mikro- und Submikrometerbereich erzeugt werden, deren Strukturperiode durch die Verschiebung des Strahlteilerelements (2) entlang seiner optischen Achse frei einstellbar ist. Eine flächige Bearbeitung eines Substrats (5), bevorzugt flächigen und/oder transparenten Substrats, ist möglich.

## Substrat

Im Sinne der Erfindung bezieht sich der Begriff Substrat auf ein Substrat dessen Oberfläche eine Ausdehnung in mehrere Raumrichtungen hat. Es kann sich bei einem Substrat, bevorzugt flächigen und/oder transparenten Substrat, um ein planares Substrat oder ein gekrümmtes Substrat, beispielsweise ein parabolisches Substrat handeln. Unter flächig ist im Sinne der Erfindung ferner zu verstehen, dass die Ausdehnung eines Substrats, bevorzugt flächigen und/oder transparenten Substrats, beispielsweise eines planaren Substrates in x und y Richtung, beziehungsweise die Ausdehnung eines gekrümmten Substrates entlang seines Krümmungsradius größer ist als die Ausdehnung des Bereichs, in dem die zumindest drei Teilstrahlen miteinander interferieren.

In einer bevorzugten Ausgestaltung handelt es sich bei dem Substrat um ein Substrat, dessen Ausdehnung in x und y Richtung, beziehungsweise dessen Ausdehnung entlang eines Krümmungsradius kleiner oder gleich der Ausdehnung des Bereichs ist, in dem die zumindest drei Teilstrahlen miteinander interferieren. Eine homogene Strukturierung des Substrats ist in einem Bearbeitungsschritt (während eines Laserpulses) möglich.

In einer besonders bevorzugten Ausgestaltung handelt es sich bei dem Substrat um ein flächiges Substrat, dessen Ausdehnung in x und y Richtung, beziehungsweise dessen Ausdehnung entlang eines Krümmungsradius größer der Ausdehnung des Bereichs ist, in dem die zumindest drei Teilstrahlen miteinander interferieren. Durch Bewegen des Substrats in der x und y Ebene ist eine flächige, homogene Strukturierung des Substrats in mehreren Bearbeitungsschritten (mit mehreren Laserpulsen) möglich. Die Bewegung des Substrats kann hierbei durch Rotation oder Translation oder durch eine Überlagerung aus Rotation und Translation erfolgen.

Im Sinne der Erfindung umfasst die Bezeichnung Substrat ein festes Material mit reflektierender Oberfläche. Beispiele für solche Materialien sind Metalle, Polymere, Keramiken und Gläser.

Hinsichtlich der Substrate, die durch die Applizierung des erfindungsgemäßen Laserinterferenzstrukturierungsverfahrens mit einer hierin definierten periodischen Punktstruktur, insbesondere mit antireflektierenden Eigenschaften bearbeitet werden können, besteht im Rahmen der vorliegenden Erfindung eine breite Auswahlmöglichkeit an transparenten und transluzenten aber auch intransparenten Materialien.

In einer besonders bevorzugten Ausführungsform umfasst das flächige Substrat ein transparentes Material.

Im Allgemeinen weist das transparente Material eine hohe Durchlässigkeit für sichtbares Licht auf, die jedoch je nach Anwendung unterschiedlich ist. Der Transmissionsgrad des transparenten Materials beträgt nicht weniger als 70%, vorzugsweise nicht weniger als 80%, noch bevorzugter nicht weniger als 90%, ohne Abweichung im Spektrum im Bereich des sichtbaren Lichts (Wellenlänge 380 nm bis 780 nm).

Die Geometrie des Substrats kann variabel sein; so können flächige Substrate, die bspw. planar sind, Krümmungen oder Oberflächenunebenheiten aufweisen, und/oder nicht-flächige Substrate, wie bspw. Röhren oder Fasern eingesetzt werden.

Vorzugsweise ist das Substrat ein flächiges und/oder transparentes Material.

Das Substrat kann als flexibles und/oder biegsames Substrat, wie bspw. eine biegsame Glasfolie, ein (Kunst-)Leder, eine Metallfolie, ein dünnes Blech oder eine Kunststofffolie, wie dies bspw. für die Anwendung in einer Solarfolie oder in Displays zum Einsatz kommt, ausgebildet sein.

In einer besonders bevorzugten Ausführungsform umfasst das flächige Substrat ein transparentes Material, vorzugsweise besteht das Substrat aus einem transparenten Material. Ein Material bzw. Substrat ist im Sinne der vorliegenden Erfindung transparent, wenn es eine hohe Durchlässigkeit für zumindest einen Teilbereich des Spektrums elektromagnetischer Strahlung zwischen 1 nm und 1 m aufweist. Derartige Teilbereiche sind beispielsweise elektromagnetische Strahlung im Bereich des sichtbaren Lichts von 380 nm bis 780 nm oder in einem Bereich, der auch infrarotes Licht umfasst, von 780 nm bis 5.000 nm oder in einem Bereich des infraroten Lichtes (Wärmestrahlung) oder in einem Bereich der Mikrowellenstrahlung, insbesondere Radarstrahlen im Wellenlängenbereich von 1 mm bis 10 m, oder auch ein anderer Teilbereich, der entsprechend der gewünschten Anwendung, insbesondere an die Wellenlänge der Laserquelle, angepasst ist. Ein solcher Teilbereich hat bevorzugt wenigstens eine Breite von 10 % oder von 50 % der Wellenlänge, welche die untere Grenze des Teilbereiches bildet. Eine hohe Durchlässigkeit in einem Teilbereich ist im Sinne der Erfindung ein Transmissionsgrad von wenigstens 50 % oder vorzugsweise wenigstens 70 % oder besonders bevorzugt wenigstens 80 % oder wenigstens 90 % für jede Wellenlänge in dem Teilbereich, also für das gesamte Spektrum in dem Teilbereich. Als ein transparentes Substrat kann aber auch ein Substrat bezeichnet werden, welches selektiv für bestimmte Wellenlängenbereiche im Bereich des sichtbaren Lichts eine hohe Durchlässigkeit aufweist, bspw. hat das Substrat eine hohe Durchlässigkeit für elektromagnetische Strahlung mit Wellenlängen im Bereich von 500 nm bis 800 nm. Dabei kann der Transmissionsgrad über den Wellenlängenbereich, welcher transmittiert wird, variieren, bspw. für Wellenlängen im Bereich von 380 nm bis 500 nm nicht weniger als 70% betragen, und im Bereich von 500 nm bis 750 nm nicht weniger als 90% betragen. Beispielsweise transmittiert das Substrat Strahlung mit Wellenlängen von 380nm bis 780nm. Besonders hohe Transmission, bspw. einen Transmissionsgrad von 90% weist es bei Wellenlängen von 450nm bis 690nm auf; der Transmissionsgrad bei den Wellenlängen darunter und darüber beträgt bspw. 70%.

Die Lichtdurchlässigkeit eines transparenten Materials bietet darüber hinaus den Vorteil, dass eine Laserinterferenzbearbeitung einer Ebene im Volumen/Innern des Substrats möglich ist.

Ein transparentes Material umfasst im Sinne der vorliegenden Erfindung transparente Materialien, insbesondere Glas (z.B. Borosilikatgläser, Quarzgläser, Alkali-Erdalkali-Silikatgläser (bspw. Kalknatronglas), Alumosilikatgläser, metallische Gläser), aber auch feste Polymere (z.B. Polycarbonate, wie Makrolon® und Apec®; Polycarbonatblends, wie Makroblend® und Bayblen®; Polymethylmethacrylat, wie Plexiglas®; Polyester; Polyethylenterephthalat, Polypropylen, Polyethylen) sowie transparente Keramiken (bspw. Spinell-Keramiken, wie Mg-Al-Spinell, ALON, Aluminiumoxid, Yttriumaluminiumgranat, Yttriumoxid oder Zirkonoxid) oder Mischungen daraus. Polycarbonate sind Homopolycarbonate, Copolycarbonate und thermoplastische Polyestercarbonate.

Nach einer besonders bevorzugten Ausgestaltung besteht das transparente Material aus einem Glas (wie hierin definiert) oder einem festen Polymer (wie hierin definiert).

Das Silikatgerüst von Glas sorgt vorzugsweise für ein Transmissionsfenster für Wellenlängen im Bereich zwischen 170 nm und 5.000 nm, d.h. Wellenlängenbereich die das sichtbare Licht im Bereich von 380 nm bis 780 nm einschließen und Infrarotstrahlung umfassen.

Alternativ dazu kann das Substrats, bevorzugt flächigen und/oder transparenten Substrats, auch ein intransparentes Material umfassen. Durch die Strukturierung des intransparenten Materials wird auf der Oberfläche des intransparenten Materials eine periodische Punktstruktur im Mikro- oder Submikrometerbereich, wie hierin definiert, erzeugt. Im Ergebnis kann hierdurch auf einem intransparenten Material eine Struktur mit Antireflexionseigenschaften erzeugt werden, wobei die ursprüngliche Rauheit der Oberfläche des intransparenten Substrates (d.h. vor dem Applizieren der erfindungsgemäßen Strukturierung) im makroskopischen Bereich unverändert bzw. nahezu unverändert bleibt, wodurch effektiv eine Reflexionsverringerung einer sonst reflektiven Oberfläche eines intransparentes Material, bspw. einer Metalloberfläche induziert wird. Als intransparente Materialien eignen sich insbesondere Metalle (z.B. Silizium, Aluminium, Kupfer, Gold), metallische Legierungen (z.B. Stahl, Messing), keramische Materialien (z.B. Zirkonoxid, Titandioxid, Zirkondioxid) und Polymeren (PEEK, Polyetheretherketone; polyfluorierde Kohlenwasserstoffe, wie Teflon) sowie Kombinationen davon. Beispielsweise eignet sich ein derart strukturiertes Substrat als Negativform zur indirekten Aufbringung oder Erzeugung von Strukturen auf einem anderen Substrat. Das so strukturierte Substrat kann bspw. als "Stempel" verwendet werden, um eine zu der auf dem Substrat erzeugten Struktur inverse Struktur auf einer beliebigen Anzahl weiterer Substrate zu erzeugen. Darüber hinaus weist ein derart strukturiertes Substrat eine erhöhte Beugung von elektromagnetischer Strahlung auf, wodurch die Strukturierung des Substrates eine Reduzierung der gerichteten Reflexion des Substrates erwirkt. Aufgrund der Strukturabmessungen treten Streuprozesse an diesen Strukturen auf, welche durch die Interferenzstrukturierung auf der Ebene des Substrates, insbesondere an einer seiner Oberflächen, eingefügt werden.

**Punktförmige Struktur/Interferenzmuster/Antireflexionsverglasung**

Von der vorliegenden Erfindung ist auch ein strukturiertes Substrat (5) mit Antireflexionseigenschaften umfasst, wobei das strukturierte Substrat eine **periodische Punktstruktur** im Mikro- oder Submikrometerbereich umfasst, wobei die periodische Punktstruktur aus inversen **Zapfen** gebildet ist, und wobei die inversen Zapfen periodisch mit einem Abstand bezogen auf deren jeweiligen Sattelpunkt bzw. Höhenmittelpunkt (kreisförmige Grundfläche) im Bereich von 50 nm bis 50 μm, bevorzugt im Bereich von 50 nm bis 20 μm, besonders bevorzugt im Bereich von 100 nm bis 4 μm, mehr bevorzugt im Bereich von 100 nm bis 2 μm, noch mehr bevorzugt im Bereich von 200 nm bis 1,5 μm, ganz besonders bevorzugt im Bereich von 300 nm bis 800 nm zueinander angeordnet sind.

Der Begriff inverser Zapfen bezieht sich im Sinne dieser Erfindung auf Strukturen mit einer kreisförmigen, elliptischen, dreieckigen oder im Wesentlichen rechteckigen Grundfläche, insbesondere mit einer kreisförmigen Grundfläche, die in vertikaler Richtung kegelförmig in das Substrat zulaufen und in deren Sattelpunkt über eine abgerundete Kegelspitze verfügen. Die inversen Zapfen werden während des Strukturierungsprozesses, d.h. beim Auftreffen eines Laserpulses als Folge des Auftreffens eines Bereiches hoher Intensität in das zu strukturierende Substrat ausgebildet, wobei die Bereiche zwischen den inversen Zapfen auf bzw. innerhalb des Substrates idealerweise durch destruktive Interferenz deren Intensität Null ist im Wesentlichen Unstrukturiert verbleiben. Folglich wird durch die Fokussierung der Laser(-teil)strahlen auf bzw. innerhalb des Substrats das Negativ von dem, was die Intensitätsverteilung vorgibt, ausgebildet. Die beschriebene Form der inversen Zapfen bezieht sich auf Punktstrukturen, welche an der Oberfläche des Substrates angeordnet sind. Eine Anordnung der Punktstrukturen in einer oder entlang einer Ebene innerhalb des Volumens führt zu einer Form welche symmetrisch ausgebildet ist. Im Sinne der Erfindung sind auch die mittels Laserinterferenzstrukturierung innerhalb eines Volumens generierten Punktstrukturen als inverse Zapfen bezeichnet.

Zapfen mit einer elliptischen Grundfläche können beispielsweise durch Neigung des Substrates im Verhältnis zum Einfallswinkel des bzw. der fokussierten Laser(-teil)strahlen, durch Neigung des Interferenzvolumens (d.h. volumetrischer Pixel, Voxel; der Winkel in dem die Teilstrahlen auf der Oberfläche oder im Volumen des Substrats fokussiert werden, sodass sie in einem Interferenzbereich interferieren) zum Substrat, bspw. durch Neigung der Apparatur zum Substrat oder durch eine Kombination davon erzeugt werden. Gemäß einer bevorzugten Ausgestaltung werden Zapfen mit einer elliptischen Grundfläche durch Neigung des Substrates im Verhältnis zum Einfallswinkel des bzw. der fokussierten Laser(-teil)strahlen erzeugt.

Die Periode der Struktur wird im Sinne der Erfindung als Λ bezeichnet. Sie ist im Allgemeinen abhängig von der Wellenlänge der interferierenden Laser(-teil)strahlen, dem Einfallswinkel der interferierenden Laser(-teil)strahlen und der Anzahl der interferierenden Laser(-teil)strahlen.

Ein strukturiertes Substrat mit Antireflexionseigenschaften, hier eine Antireflexionsverglasung genannt, beschreibt im Sinne der Erfindung ein Substrat, bevorzugt flächiges und/oder transparentes Substrat, mit einer periodischen Punktstruktur mit Strukturweiten im Mikro- und Submikrometerbereich, also im Bereich von 50 nm bis 50 μm. Diese Antireflexionseigenschaften kommen zustande, wenn die Abmessungen der erzeugten Struktur, also die Strukturperiode und Abmessung der einzelnen Zapfen, in Bereichen kleiner als die Wellenlänge des sichtbaren Lichts liegen.

Unter Reflexion versteht man in der Physik das Zurückwerfen von einer elektromagnetischen Welle an einer Grenzfläche von Materialien unterschiedlichen Brechungsindexes. Der Reflexionswinkel und der Transmissionswinkel von Licht in transparenten Substraten können allgemein über das Snelliussche Brechungsgesetz berechnet werden zu

$$n_1 sin\delta_1 = n_2 sin\delta_2$$

berechnet, wobei $n_1$ und $n_2$ den Brechungsindex von Luft und dem Substrat angeben und $\delta_1$ und $\delta_2$ jeweils die Winkel des einfallenden und reflektierten Strahls angeben.

Durch die periodische Punktstruktur auf der Oberfläche oder im Volumen des Substrats, bevorzugt flächigen und/oder transparenten Substrats, verändert sich der Brechungsindex des Substrats in der Form, dass sich ein gradueller Brechungsindex ergibt. Das hat zur Folge, dass Licht mit Wellenlängen größer der Strukturperiode Λ der periodischen Punktstruktur vermehrt transmittiert wird. Licht mit Wellenlängen kleiner oder gleich der periodischen Punktstruktur wird an der Oberfläche gebeugt.

Antireflexionseigenschaften bezeichnen im Sinne der Erfindung periodische Punktstrukturen, deren Abmessungen im Bereich der einfallenden elektromagnetischen Welle liegen, sodass die einfallende Welle derart vom Betrachter weggebeugt wird, dass keine Reflexion als "störend" wahrgenommen wird. Zusätzlich umfasst der Begriff Antireflexionseigenschaften im Sinne der Erfindung auch, dass der Brechungsindex an der Grenze zwischen dem ersten Medium, zum Beispiel Luft, und dem Substrat, bevorzugt flächigen und/oder transparenten Substrat, graduell ist, sodass für die einfallende elektromagnetische Welle kein klarer Übergang von einem Medium zum anderen vorhanden ist und die einfallende elektromagnetische Welle vermehrt transmittiert wird.

Im Sinne der Erfindung beschreibt ein strukturiertes Substrat mit Antireflexionseigenschaften auch ein solches Substrat, welches eine periodische Punktstruktur umfasst, wobei die periodische Punktstruktur aus sich überlagernden Strukturen besteht, wobei mindestens eine Struktur Abmessungen im Submikrometerbereich aufweist, und wobei zumindest eine Struktur aus inversen Zapfen (wie hierin definiert) gebildet ist, welche insbesondere durch interferierende Laserstrahlen erzeugbar sind.

Beispielsweise lässt sich die periodische Punktstruktur, insbesondere die periodische Punktstruktur aus sich überlagernden Strukturen bei dem Einsatz von interferierenden Laserstrahlen durch entsprechende Ausgestaltung der Parameter (Auswahl der Laserstrahlungsquelle, Anordnung der optischen Elemente, Pulsdauer und -intensität, Anzahl der Laserpulse, welche auf ein Interferenzpixel treffen) an die Anforderungen der jeweiligen Anwendung optimal anpassen.

Beispielsweise handelt es sich bei einer so erzeugten Struktur mit Antireflexionseigenschaften um eine periodische Punktstruktur aus inversen Zapfen mit mittleren Abmessungen im Mikrometerbereich, insbesondere mit einem mittleren Abstand bezogen auf deren jeweiligen Sattelpunkt bzw. Höhenmittelpunkt von 1 μm bis 50 μm. Dieser periodischen Punktstruktur ist eine weitere Struktur überlagert, wobei die mittlere Abmessung der überlagernden Struktur bevorzugt Abmessungen im Bereich der Laserwellenlänge λ, bzw. λ/2, insbesondere von 100 nm bis 1000 nm, vorzugsweise 100 nm bis 800 nm, besonders bevorzugt 100 nm bis 600 nm, insbesondere 100 nm bis 400 nm aufweist. Im Sinne der Erfindung wird eine solche Struktur auch als hierarchische Struktur bezeichnet.

Insbesondere weist die sich überlagernde Struktur eine quasi-periodische Wellenstruktur auf, wobei das Material auf der Oberfläche des Substrats im Bereich der sich überlagernden Struktur eine Abfolge von Wellenbergen und Wellentälern aufweist, deren Periodizität im Submikrometerbereich, besonders bevorzugt im Bereich von 100 nm bis 1000 nm, vorzugsweise im Bereich von 100 nm bis 800 nm, besonders bevorzugt 100 nm bis 600 nm, insbesondere 100 nm bis 400 nm liegt.

Die Wellenstruktur wird während des Strukturierungsprozesses, d.h. beim Auftreffen eines Laserpulses in das zu strukturierende Substrat als Folge des Auftretens eines Bereiches hoher Intensität ausgebildet, wobei die Strukturierung durch einen Selbstorganisationsprozess erfolgt, welcher durch das zumindest teilweise Aufschmelzen des Substratmaterials mittels eines Laserpulses in einem Bereich hoher Intensität angeregt wird. Insbesondere wird die Wellenstruktur unter Ausnutzen von laser-induzierten periodischen Oberflächenstrukturen (engl. Laser-induced Periodic Surface Structures - LIPSS) erzeugt, wobei das Auftreten dieser Oberflächenstrukturen an das Erzeugen der periodischen Punktstrukturen mittels interferierender Laserstrahlen gekoppelt ist.

Alternativ dazu kann die Wellenstruktur, die die erfindungsgemäße Punktstruktur aus inversen Zapfen mit mittleren Abmessungen im Mikrometerbereich überlagert, auch durch ein nachfolgendes Applizieren eines weiteren Interferenzpixels auf die Oberfläche des (vor-strukturierten) Substrates erfolgen aufgebracht werden, wobei die mit dem weiteren Interferenzpixel generierten Strukturen eine Strukturperiode bezogen auf die Zapfen, die durch das weitere Interferenzpixel gebildet sind, im statistischen Mittel im Bereich von 100 nm bis 1.000 nm, vorzugsweise im Bereich von 100 nm bis 800 nm, besonders bevorzugt 100 nm bis 600 nm, bspw. im Bereich von 200 nm bis 500 nm, insbesondere im Bereich von 100 nm bis 400 nm aufweisen.

Vorteilhaft ist somit eine flächige Strukturierung eines Substrats, bspw. mit Antireflexionseigenschaften durch interferierende Laserstrahlen und unter Ausnutzen von laser-induzierten periodischen Oberflächenstrukturen möglich, ohne eine lange Bearbeitungszeit oder eine hohe Anzahl an sukzessiv ausführbaren Prozessschritten in Kauf zu nehmen. Die Erfindung ermöglicht somit ein simultanes Erzeugen von hierarchischen Strukturen, welche im technischen Bereich sowohl im Bereich von Substraten mit Antireflexionseigenschaften, als auch im Bereich von selbstreinigenden, hydrophoben oder superhydrophoben, sowie hydrophilen oder superhydrophilen Substraten mit anti-icing und/oder anti-fogging Eigenschaften einsetzbar sind.

Nach einer bevorzugten Ausgestaltung der vorliegenden Erfindung erfolgt das Applizieren eines Interferenzpixels (bzw. des Interferenzvolumens, der das Interferenzpixel auf bzw. im Substrat erzeugt), bspw. eines ersten, eines zweiten und/oder eines dritten Interferenzpixels auf die Oberfläche oder in das Volumen des Substrates mittels Laserinterferenzstrukturierung durch eine Bestrahlung des Substrates mit mehreren Laser(teil-)strahlen in einem Winkel zur Oberfläche des Substrates von 45° bis 90° (senkrecht), bevorzugt in einem Winkel von 60° bis 90°, besonders bevorzugt in einem Winkel von 75° bis 90°, bspw. jeweils in einem Winkelbereich von/bis 76°, 77°, 78°, 79°, 80°, 81°, 82°, 83°, 84°, 85°, 86°, 87°, 88°, 89°, 90° jeweils bezogen auf die optische Achse des Substrats. Ganz besonders bevorzugt erfolgt das Applizieren eines Interferenzpixels auf die Oberfläche eines Substrates im Wesentlichen senkrecht entlang einer Normalen zur Oberfläche, d.h. in einem Winkel von 90° ± 1°.

## Interferenzbereich, bzw. Interferenzpixel

Die erfindungsgemäße Vorrichtung ist dazu ausgelegt, eine **periodische Punktstruktur** im Mikro- oder Submikrometerbereich auf einem Substrat zu erzeugen, wobei die periodische Punktstruktur durch in einem Interferenzbereich interferierende Laserstrahlen erzeugbar ist. Der Interferenzbereich ist durch innerhalb seiner räumlichen Ausdehnung auftretende, alternierende Strahlungsintensitätsmaxima und -minima gekennzeichnet. Diese Maxima und Minima treten mit einer periodischen, d.h. sich wiederholenden Regelmäßigkeit auf und bilden somit ein Interferenzmuster, welches auf das Substrat übertragbar ist. Der Interferenzbereich, innerhalb dessen dieses Muster erkennbar ist, wird auch als Interferenzpixel bezeichnet. Die Ausdehnung des Interferenzpixel ist typischerweise kreisförmig, aber auch andere geometrische Ausdehnungen, bspw. ellipsenförmige oder linienförmige Ausdehnungen sind denkbar. Der Interferenzbereich, innerhalb dessen das Interferenzmuster erkennbar ist, ist dabei physikalisch durch die Intensitätsschwelle des zu bearbeitenden Substrats festgelegt. Die Intensitätsschwelle bezeichnet die Energie, bei welcher das Material des Substrats mit den einfallenden Laserstrahlen wechselwirkt, sodass eine Veränderung innerhalb des Materials, bspw. Aufschmelzen, bzw. Abtragen des Materials stattfindet. Bei einer Laserstrahlungsquelle mit einem Gauß-förmigen Strahlungsprofil nimmt die an den Maxima des Interferenzmusters auftretende Energie der interferierenden Laserstrahlen zum Rand des Interferenzbereiches hin ab, sodass der auf dem Substrat aufgebrachte Interferenzpixel in seiner Ausmessung kleiner ist als der Interferenzbereich, wobei die genaue Größe durch die Eigenschaften der Laserstrahlungsquelle und des Substrats vorgegeben wird.

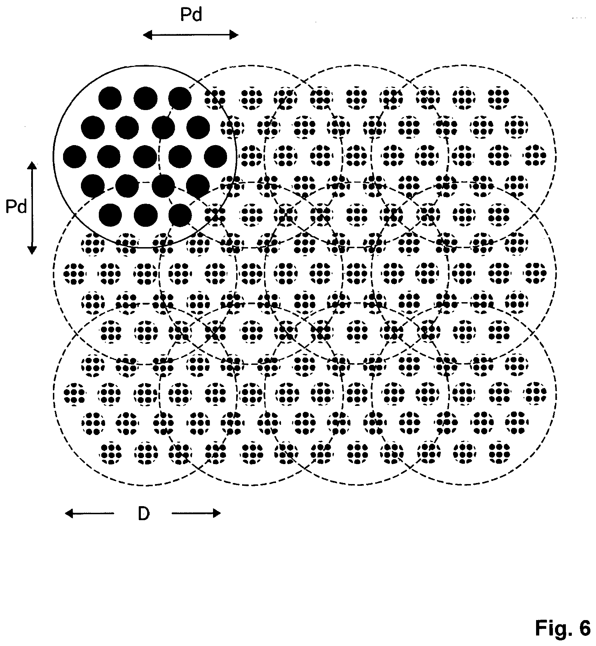

Der Begriff Interferenzpixel, bspw. erstes, zweites, drittes und/oder weiteres Interferenzpixel bezeichnet im Sinne der vorliegenden Erfindung somit ein periodisches Muster bzw. Gitter von zumindest drei inversen Zapfen, vorzugsweise von zumindest sieben inversen Zapfen, ganz besonders bevorzugt zumindest 19 inversen Zapfen auf der Oberfläche eines Substrates, die sich innerhalb eines Interferenzpixels ausbilden (vgl. Fig. 6). Vorzugsweise wird das periodische Muster bzw. Gitter durch das Überlagern von zumindest drei, besonders bevorzugt von zumindest vier Laser(teil-)strahlen infolge des Fokussierens (Bündelns) dieser Laser(teil-)strahlen auf die Oberfläche oder in das Innere des Substrats erzeugt, wodurch die Teilstrahlen auf der Oberfläche oder im Inneren des Substrats konstruktiv und destruktiv interferieren.

Nach einer bevorzugten Ausgestaltung der vorliegenden Erfindung umfasst das strukturierte Substrat nicht bloß ein einzelnes Interferenzpixel einer Art, bspw. eines ersten Interferenzpixels, eines zweiten Interferenzpixels und/oder eines dritten Interferenzpixels, sondern es sind mehrere Interferenzpixel einer Art, bspw. mehrere erste Interferenzpixel und/oder mehrere zweite Interferenzpixel jeweils unabhängig voneinander innerhalb einer Ebene in zumindest einer Raumrichtung (x- und/oder y-Ausrichtung), besonders bevorzugt in zwei Raumrichtungen (flächig), benachbart repetitiv versetzt zueinander angeordnet. So kann bspw. vorgesehen sein, dass in einem ersten Schritt zumindest mehrere erste Interferenzpixel innerhalb einer Ebene in zumindest eine Raumrichtung benachbart repetitiv versetzt zueinander angeordnet auf eine Ebene auf einer Oberfläche oder im Volumen des zu strukturierenden Substrates appliziert werden (siehe bspw. Fig. 6) und in einem zweiten Schritt diesen mehreren ersten Interferenzpixel mehrere zweite Interferenzpixel innerhalb einer Ebene in zumindest die gleiche Raumrichtung benachbart repetitiv versetzt zueinander überlagert appliziert werden. Gleichwohl kann vorgesehen sein, dass diese mehreren ersten Interferenzpixel und mehreren zweiten Interferenzpixel alternierend, also abwechselnd - d.h. ein erstes Interferenzpixel, dann ein zweites Interferenzpixel und erneut von vorn - auf die Ebene appliziert werden.

Durch das Anordnen mehrerer erster Interferenzpixel und mehrerer zweiter Interferenzpixel können gezielt Eigenschaften, insbesondere Antireflexionseigenschaften über einen großen Bereich insbesondere flächig auf eine Ebene des Substrates, die durch eine Oberfläche des Substrates aufgespannt wird, oder innerhalb des Volumens des Substrates erreicht /aufgebracht werden. Eine derartige Strukturierung mit mehreren ersten Interferenzpixeln und mehreren zweiten Interferenzpixeln kann bspw. durch ein Abscannen des Substrates mit einem Polygonscanner erfolgen.

Vorzugsweise weisen die periodischen Punktstrukturen innerhalb einer Art eines Interferenzpixels einen Variationskoeffizienten (ein Wert, der sich aus der Teilung der Standardabweichung durch den Durchschnittswert ergibt) des Zapfenquerschnitts von 15% oder weniger, mehr bevorzugt 10% oder weniger, noch mehr bevorzugt 5% oder weniger auf. Dies erlaubt zudem eine bessere Nachweisbarkeit des erfindungsgemäß strukturierten Substrates gegenüber herkömmlichen Verfahren zur Strukturierung/Beschichtung von Substraten (bspw. Ätzen, Partikelstrahlen, Polymerbeschichtung), bei welchen die Abweichungen Prozessbedingt größer ausfallen und die zu erzeugende Strukturperiode weniger genau abgebildet wird.

## Laserstrahlungsquelle (1)

Die erfindungsgemäße Vorrichtung weist eine Laserstrahlungsquelle (1) auf, die einen Laserstrahl emittiert. Das Strahlungsprofil des emittierten Laserstrahls entspricht entweder einem Gauß-Profil, oder einem Top-Hat-Profil, besonders bevorzugt einem Top-Hat-Profil. Das Top-Hat-Profil ist hilfreich, um eine zu strukturierende Oberfläche eines Substrates homogener zu strukturieren bzw. abzudecken und um ggf. eine schnellere Strukturierungsrate zu ermöglichen.

In einer besonders bevorzugten Ausgestaltung handelt es sich bei der Laserstrahlungsquelle (1) um eine Quelle, die einen gepulsten Laserstrahl erzeugt. Die Pulsweite der gepulsten Laserstrahlungsquelle liegt dabei beispielsweise im Bereich von 10 Femtosekunden bis 100 Nanosekunden, insbesondere 50 Femtosekunden bis 10 Nanosekunden, ganz besonders bevorzugt 50 Femtosekunden bis weniger als 100 Pikosekunden.

Mit Laserstrahl oder Teilstrahl ist, wenn nicht ausdrücklich anderes angegeben ist, kein idealisierter Strahl der geometrischen Optik gemeint, sondern ein realer Lichtstrahl, wie beispielsweise ein Laserstrahl, der keinen infinitesimal kleinen, sondern einen ausgedehnten Strahlquerschnitt (Gauß-Verteilungsprofil oder einen intrinsischer Top-Hat-Strahl) aufweist.

Mit Top-Hat-Profil oder Top-Hat-Intensitätsverteilung ist eine Intensitätsverteilung gemeint, die sich zumindest hinsichtlich einer Richtung im Wesentlichen durch eine Rechteckfunktion (rect (x)) beschreiben lässt. Dabei sind reale Intensitätsverteilungen, die Abweichungen von einer Rechteckfunktion im Prozentbereich beziehungsweise geneigte Flanken aufweisen, ebenfalls als Top-Hat-Verteilung oder Top-Hat-Profil bezeichnet.

Verfahren und Vorrichtungen zur Erzeugung eines Top-Hat-Profils sind dem Fachmann bestens bekannt und bspw. in EP 2 663 892 beschrieben. Ebenso sind bereits optische Elemente zur Transformation des Intensitätsprofils eines Laserstrahls bekannt. Beispielsweise können mittels diffraktiven und/oder refraktiven Optiken Laserstrahlen mit gaußförmigem Intensitätsprofil in Laserstrahlen transformiert werden, welche in einer oder mehreren definierten Ebenen ein Top-Hat-förmiges Intensitätsprofil aufweisen, wie zum Beispiel ein Gauss-to-Top Hat Focus Beam Shaper der Firma TOPAG Lasertechnik GmbH, siehe z.B. DE102010005774A1. Derartige Laserstrahlen mit Top-Hat-förmigem Intensitätsprofilen sind besonders attraktiv für die Lasermaterialbearbeitung, insbesondere bei der Verwendung von Laserpulsen, die kürzer als 50 ps sind, da mit der im Wesentlichen konstanten Energie- bzw. Leistungsdichte hierbei besonders gute und reproduzierbare Bearbeitungsergebnisse erzielt werden können.

Die in der erfindungsgemäßen Vorrichtung enthaltene Laserstrahlungsquelle (1) kann eine Intensität von 0,01 bis 5 $J/cm^2$, besonders bevorzugt 0,1 bis 2 $J/cm^2$, ganz besonders bevorzugt 0,1 bis 0,5 $J/cm^2$. Durch die erfindungsgemäße Vorrichtung ist die Intensität der Laserstrahlungsquelle in einem Bereich flexibel wählbar. Der Strahldurchmesser spielt für das Erzeugen des Interferenzmusters auf dem Substrat, bevorzugt flächigen und/oder transparenten Substrat, keine Rolle. Durch die bevorzugte Anordnung der optischen Elemente im Strahlengang des Lasers ist keine Einheit zur Kontrolle der Intensität des Laserstrahls notwendig.

Die Laserstrahlungsquelle ist vorzugsweise dazu eingerichtet, Wellenlängen im Bereich von 200 nm bis 15 $\mu$m (bspw. $CO_2$-Laser im Bereich von 10,6 $\mu$m), ganz besonders bevorzugt im Bereich von 266 nm bis 1.064 nm zu emittieren. Als Laserstrahlungsquelle eignen sich beispielsweise UV-Laserstrahlquellen, Laserstrahlquellen (155 bis 355 nm), die grünes Licht (532 nm), Diodenlaser (typischerweise 800 bis 1000 nm) oder Laserstrahlquellen, die im nahen infrarot (typischerweise 1064 nm) Strahlung emittieren, insbesondere mit einer Wellenlänge im Bereich von 200 bis 650 nm Wellenlänge. Für die Mikroverarbeitung geeignete Laser sind dem Fachmann bekannt und umfassen beispielsweise HeNe-Laser, HeAg-Laser (ca. 224 nm), NeCu-Laser (ca. 249 nm), Nd:YAG Laser (ca. 355 nm), YAG-Laser (ca. 532 nm), InGaN-Laser (ca. 532 nm).

Nach einer weiteren Ausgestaltung weist die erfindungsgemäße Vorrichtung mindestens eine weitere Laserstrahlungsquelle auf, welche derart ausgestaltet ist, dass sie einen Laserstrahl erzeugt, welcher mit dem Laserstrahl der ersten Laserstrahlungsquelle, bzw. dem in Teilstrahlen aufgeteilten Laserstrahl der ersten Laserstrahlungsquelle in einem Interferenzbereich interferiert. Dabei weist die weitere Laserstrahlungsquelle die gleichen Eigenschaften, wie oben beschrieben auf, wobei diese denen der ersten Laserstrahlungsquelle gleichen oder von dieser verschieden sein können.

## Optische Elemente

Die vorliegende Erfindung umfasst eine Vielzahl an optischen Elementen. Bei diesen Elementen handelt es sich primär um Prismen und Linsen.

Diese Linsen können refraktiv oder diffraktiv sein. Es können sphärische, asphärische oder zylindrische Linsen verwendet werden. In einer bevorzugten Ausgestaltung werden zylindrische Linsen verwendet. Dadurch ist es möglich, die Überlappungsbereiche der Teilstrahlen (hierin auch als Interferenzpixel bezeichnet) in eine Raumrichtung zu komprimieren und in eine andere zu strecken. Wenn die Linsen nicht sphärisch/asphärisch sind, sondern zylindrisch, hat dies den Vorteil, dass die Strahlen zugleich verformt werden können. Dadurch kann der Bearbeitungsspot (d.h. das auf dem Substrat erzeugte Interferenzmuster) von einem Punkt zu einer Linie verformt werden, die das Interferenzmuster enthält. Mit ausreichender Energie des Lasers kann diese Linie im Bereich von 10-15 mm lang sein (und ca. 100 $\mu$m dick sein).

Des Weiteren können Spatial Light Modulators (SLM) zur Strahlformung eingesetzt werden. Dem Fachmann ist die Verwendung von SLMs zur räumlichen Modulation der Phase oder der Intensität oder der Phase und Intensität eines einfallenden Lichtstrahls bekannt. Die Anwendung von Liquid Crystal on Silicon (LCoS)-SLM zur Strahlteilung ist in der Literatur beschrieben und auch in der erfindungsgemäßen Vorrichtung denkbar. Darüber hinaus können SLMs auch zur Fokussierung der Teilstrahlen auf dem Substrat verwendet werden. Die Ansteuerung eines solchen SLMs kann optisch, elektronisch, oder akustisch erfolgen.

Alle im Folgenden erläuterten optischen Elemente sind im Strahlengang (3) des Lasers angeordnet. Im Sinne der Erfindung bezeichnet der Strahlengang des Lasers den Verlauf sowohl des von der Laserstrahlungsquelle emittierten Laserstrahls als auch den Verlauf der durch ein Strahlteilerelement aufgeteilten Teilstrahlen. Als optische Achse des Strahlengangs (3) wird jedoch die optische Achse des von der Laserstrahlungsquelle (1) emittierten Laserstrahls verstanden. Sofern nicht anders erläutert, sind alle optischen Elemente senkrecht zur optischen Achse des Strahlengangs (3) angeordnet.

### Strahlteilerelement (2)

Im Strahlengang (3) des Lasers, hinter der Laserstrahlungsquelle (1), befindet sich ein Strahlteilerelement (2). Das Strahlteilerelement (2) kann ein diffraktives oder ein refraktives Strahlteilerelement sein. Diffraktive Strahlteilerelemente werden auch nur kurz als diffraktives optisches Element (DOE) bezeichnet. Im Sinne der Erfindung bezeichnet ein diffraktives Strahlteilerelement ein optisches Element, welches Mikro- oder Nanostrukturen, vorzugsweise Mikrostrukturen, welche einen Eingangsstrahl entsprechend den unterschiedlichen Beugungsordnungen in verschiedene Strahlen aufteilen, enthält. Ein refraktives Strahlteilerelement bezeichnet im Sinne der Erfindung ein Strahlteilerelement, bei dem die Strahlen aufgrund von Brechzahlunterschieden an Oberflächen geteilt werden, wobei diese in der Regel transparent ausgebildete optische Elemente sind, wie z. B. ein Prisma bzw. ein Doppelprisma. Vorzugsweise handelt es sich bei dem Strahlteilerelement (2) um ein diffraktives optisches Strahlteilerelement.

Nach einer bevorzugten Ausgestaltung handelt es sich bei dem Strahlteilerelement um ein einzelnes optisches Element, insbesondere ein diffraktives oder refraktives optisches Element, welches derart aufgebaut ist, dass die Unterteilung des einfallenden Laserstrahls auf den optischen Eigenschaften des Strahlteilerelements basiert. Somit ist vorteilhaft gewährleistet, dass gegenüber einem mehrteiligen Strahlteilerelement, welches aus mehreren optischen Elementen (bspw. Spiegel, Prismen, etc.) besteht, ein einfacher optischer Aufbau realisierbar ist. Die gewünschte Strahlaufteilung ist erreichbar, ohne dass ein Kalibrieren, bzw. Anpassen der Anordnung von mehreren optischen Elementen zueinander notwendig ist. Auch ist die Beweglichkeit des Strahlteilerelements im Strahlenganz einfach zu realisieren, da nur das Bewegen eines einzelnen optischen Elements durchzuführen ist. Zudem ergeben sich durch das Verwenden eines einteiligen Strahlteilerelements weniger verschleißanfällige Komponenten, welche ggf. auszutauschen sind.

Nach einer möglichen Ausgestaltung ist der Strahlteiler als polarisierender Strahlteiler, bei dem einer der resultierenden Strahlen eine andere Polarisation aufweist als der andere, oder als nicht polarisierender Strahlteiler, bei dem die Polarisation für die Teilung des Strahls keine Rolle spielt, ausgebildet.

In einer bevorzugten Ausgestaltung teilt das Strahlteilerelement (2) den emittierten Laserstrahl in zumindest 3, vorzugsweise zumindest 4, insbesondere 4 bis 8, also 4, 5, 6, 7, oder 8 Teilstrahlen auf.

In einer weiteren Ausgestaltung teilt das Strahlteilerelement (2) den emittierten Laserstrahl in zumindest 2, vorzugsweise zumindest 3 bis 4, insbesondere 4 bis 10, also 4, 5, 6, 7, 8, 9 oder 10 Teilstrahlen auf.

Das Strahlteilerelement (2) ist entlang seiner optischen Achse frei beweglich. D. h., es kann entlang seiner optischen Achse auf die Laserstrahlungsquelle zu oder von ihr wegbewegt werden. Durch die Bewegung des Strahlteilerelements (2) verändert sich die Aufweitung der zumindest 3 Teilstrahlen, sodass diese mit unterschiedlichen Abständen zueinander auf ein Fokussierelement auftreffen. Dadurch kann der Winkel $\theta$, in dem die Teilstrahlen auf das Substrat (5), bevorzugt flächiges und/oder transparentes Substrat, auftreffen, verändert werden. Somit ergibt sich bei einer Überlagerung von vier Teilstrahlen eine nahtlose Änderung der Strukturperiode $\Lambda$ zu

$$\Lambda = \frac{\lambda}{\sqrt{2}sin\theta}$$

wobei $\lambda$ die Wellenlänge des emittierten Laserstrahls ist.

Nach einer bevorzugten Ausgestaltung der vorliegenden Erfindung ist das Strahlteilerelement als rotierendes Element ausgebildet. Dies erlaubt es vorteilhaft, dass die Polarisation der Teilstrahlen modifiziert werden können.

Besonders bevorzugt beträgt der Winkel $\theta$, in dem die Teilstrahlen auf das Substrat (5), bevorzugt flächiges und/oder transparentes Substrat, auftreffen, 0,1° bis 89,9°, bevorzugt 5° bis 85°, besonders bevorzugt 10° bis 60°, ganz besonders bevorzugt 15° bis 45°.

Der Winkel $\theta$ ist ferner abhängig von den Abständen der optischen Elemente untereinander, insbesondere vom Abstand der optischen Elemente zum Strahlteilerelement, ganz besonders vom Abstand des Fokussierelements zum Strahlteilerelement. Abhängig von der gewünschten Strukturperiode, welche auf, bzw. im flächigen und/oder transparenten Substrat zu erzeugen ist, kann die Position des Strahlteilerelements so eingestellt bzw. berechnet werden, dass die gewünschte Strukturperiode einstellbar ist. Dabei wird die Position der von der Vorrichtung umfassten optischen Elemente, insbesondere die Position des Fokussierelements derart im Verhältnis zum Strahlteilerelement berücksichtigt, dass bei einem größeren oder kleineren Abstand der optischen Elemente zueinander die Position des Strahlteilerelements entsprechend anpassbar ist.

Um ein strukturiertes Substrat mit Antireflexionseigenschaften zu generieren hat sich als besonders vorteilhaft herausgestellt, wenn ein Abstand vom Strahlteilerelement (2) zum Umlenkelement (7) von 10 bis 300 nm, eingestellt ist.

Gemäß einer Ausführungsform können punktförmige Strukturen, die kleine Strukturperioden, vorzugsweise im statistischen Mittel im Bereich von 100 nm bis 1.000 nm (bzw. wie weiterhin hierin definiert) aufweisen, direkt durch Applizieren eines Interferenzmusters erzeugt werden, wobei der Abstand zwischen dem Strahlteilerelement (2) und dem Umlenkelement (7) groß ist, bspw. im Bereich von 40 mm bis 200 mm, insbesondere 80 mm bis 150 mm liegt.

Gemäß einer weiteren Ausführungsform können punktförmige Strukturen, die kleine Strukturperioden, vorzugsweise im statistischen Mittel im Bereich von 100 nm bis 1.000 nm (bzw. wie weiterhin hierin definiert) aufweisen, durch einen Selbstorganisationsprozess der LIPSS erzeugt werden, wobei der Abstand zwischen dem Strahlteilerelement (2) und dem Umlenkelement (7) klein ist, bspw. im Bereich von 1 mm bis 100 mm, insbesondere 50 mm bis 75 mm, besonders bevorzugt 10 bis 50 mm liegt. Hierdurch kann durch direktes Applizieren eines Interferenzmusters ein Interferenzmuster erzeugt werden, das große Strukturperioden aufweist, dem die Punktstruktur im Submikrometerbereich (wie hierin definiert) überlagert ist.

Nach einer bevorzugten Ausgestaltung der Erfindung umfasst die Vorrichtung auch eine Messeinrichtung, insbesondere eine Messeinrichtung, die mittels eines Lasers oder eines optischen Sensors arbeitet, die zum Messen der Position des Strahlteilerelements und gegebenenfalls des Abstandes des Strahlteilerelements zu den weiteren optischen Elementen, insbesondere zur Position des Fokussierelements eingerichtet ist.

Ferner kann die erfindungsgemäße Vorrichtung eine mit der Messeinrichtung signaltechnisch verbundene Steuereinrichtung umfassen, die insbesondere mit einer Recheneinheit derart verbunden ist, mit der die gemessenen Position des Strahlteilerelements mit einem ersten vorbestimmten Vergleichswert vergleichbar ist, wobei die Steuereinrichtung programmtechnisch derart eingerichtet ist, dass, falls der Abstand des Strahlteilerelements zu den weiteren optischen Elementen, insbesondere zur Position des Fokussierelements und/oder des Umlenkelements (7) größer oder kleiner ist als der erste vorbestimmte Vergleichswert, dann über die Steuereinrichtung ein Steuersignal erzeugt wird, mit dem zumindest eine Position eines optischen Elements, insbesondere des Strahlteilerelements (2) derart verändert wird, insbesondere des Strahlteilerelements (2) im Verhältnis zum Umlenkelement (7), dass die gewünschte Strukturperiode auf dem Substrat erzeugt wird.

In diesem Zusammenhang kann auch das Verfahren zur Herstellung eines Substrats mit einer Punktstruktur im Mikro- oder Submikrometerbereich insbesondere nach Schritt (a) die folgenden Schritte umfassen:

(i) Messen der Position des Strahlteilerelements (2) und gegebenenfalls des Abstandes des Strahlteilerelements zu den weiteren optischen Elementen oder zu wenigstens einem der weiteren optischen Elemente, insbesondere zur Position des Fokussierelements (4) und/oder des Umlenkelements (7),

(ii) Vergleichen der gemessenen Position des Strahlteilerelements mit einem ersten vorbestimmten Vergleichswert, und

(iii) falls der gemessene Abstand des Strahlteilerelements zu den weiteren optischen Elementen oder zu wenigstens einem der weiteren optischen Elemente, insbesondere zur Position des Fokussierelements (4) und/oder des Umlenkelements (7) größer oder kleiner ist als der erste vorbestimmte Vergleichswert: Verändern der Position des optischen Elements, insbesondere des Strahlteilerelements (2) derart (insbesondere im Verhältnis zu den anderen optischen Elementen, besonders bevorzugt des Strahlteilerelements (2) im Verhältnis zum Umlenkelement (7)), dass die gewünschte Strukturperiode auf dem Substrat erzeugt wird.

Das Unterteilen des Laserstrahls im Strahlteilerelement (2) kann sowohl durch ein teilweise reflektives Strahlteilerelement, beispielsweise einen halbdurchlässigen Spiegel, als auch ein transmissives Strahlteilerelement, beispielsweise ein dichroitisches Prisma, erfolgen.

In einer bevorzugten Ausgestaltung sind dem Strahlteilerelement (2) weitere Strahlteilerelemente im Strahlengang des Lasers nachgeordnet. Diese Strahlteilerelemente sind derart angeordnet, dass sie jeden der zumindest drei Teilstrahlen in zumindest zwei weitere Teilstrahlen aufteilen. Dadurch kann eine höhere Anzahl an Teilstrahlen erzeugt werden, die auf das Substrat, bevorzugt flächige und/oder transparente Substrat, gelenkt werden, sodass sie auf der Oberfläche oder im Inneren des Substrats interferieren. Dadurch kann die Strukturperiode des Interferenzmusters eingestellt werden.

*Fokussierelement (4)*

Des Weiteren ist im Strahlengang (3) des Lasers dem Strahlteilerelement (2) nachgeordnet ein Fokussierelement (4) angeordnet, das derart eingerichtet ist, dass es die Teilstrahlen derart durchlaufen, dass die Teilstrahlen auf der Oberfläche oder im Inneren eines zu strukturierenden Substrats (5) in einem Interferenzbereich interferieren. Das Fokussierelement (4) fokussiert die zumindest drei Teilstrahlen in einer Raumrichtung, ohne die zumindest drei Teilstrahlen in der Raumrichtung senkrecht dazu zu fokussieren. Beispielsweise kann das Fokussierelement (4) eine fokussierende optische Linse sein. Unter fokussieren versteht man im Sinne der Erfindung das Bündeln der zumindest drei Teilstrahlen auf der Oberfläche oder im Inneren eines Substrates, bevorzugt eines flächigen und/oder transparenten Substrates.

Das Fokussierelement (4) kann im Strahlengang (3) frei beweglich sein. Nach einer bevorzugten Ausgestaltung der vorliegenden Erfindung ist das Fokussierelement (4) im Strahlengang bzw. entlang der optischen Achse fixiert.

Es versteht sich, dass die hierin definierten optischen Elemente bspw. zur Strahlteilung und zur Ausrichtung der Teilstrahlen in Richtung auf ein entsprechend zu strukturierendes Substrat in einem gemeinsamen Gehäuse angeordnet sein können.

In einer bevorzugten Ausgestaltung handelt es sich bei dem Fokussierelement (4) um eine sphärische Linse. Die sphärische Linse ist derart eingerichtet, dass sie die einfallenden zumindest drei Teilstrahlen derart durchlaufen, dass sie auf der Oberfläche oder im Inneren des zu strukturierenden Substrats (5), bevorzugt flächigen und/oder transparenten Substrats, in einem Interferenzbereich interferieren. Die Weite des Interferenzbereichs beträgt vorzugsweise 1 bis 600 $\mu$m, besonders bevorzugt 10 bis 400 $\mu$m, ganz besonders bevorzugt 20 bis 200 $\mu$m. Hierdurch kann zugleich eine hohe Strukturierungsrate, beispielsweise wie hierin definiert, eingestellt werden.

In einer besonders bevorzugten Ausgestaltung handelt es sich bei dem Fokussierelement (4) um eine zylindrische Linse. Die zylindrische Linse ist derart eingerichtet, dass der Bereich, in dem sich die zumindest drei Teilstrahlen auf der Oberfläche oder im Inneren des Substrats (5), bevorzugt flächigen und/oder transparenten Substrats, überlagern, in eine Raumrichtung gedehnt wird. Dadurch nimmt der Bereich des Substrats, auf dem das Interferenzmuster erzeugt werden kann, eine elliptische Form an. Die große Halbachse dieser Ellipse kann eine Länge von 20 $\mu$m bis 15 mm erreichen. Damit vergrößert sich der in einer Bestrahlung strukturierbare Bereich.

*Erstes Umlenkelement (7)*

In einer besonders bevorzugten Ausgestaltung befindet sich vor dem Fokussierelement (4) und nach dem Strahlteilerelement (2) angeordnet ein Umlenkelement (7), das vorzugsweise im Strahlengang (3) des Lasers angeordnet ist. Dieses Umlenkelement (7) wird zum Aufweiten der Abstände zwischen den zumindest drei Teilstrahlen genutzt und kann damit ebenfalls den Winkel, in dem die Teilstrahlen auf das Substrat (5), bevorzugt flächiges und/oder transparentes Substrat, auftreffen, verändern. Es ist derart eingerichtet, dass es die Divergenz der zumindest drei Teilstrahlen erhöht und damit den Bereich, in dem die zumindest drei Teilstrahlen interferieren, entlang der optischen Achse des Strahlengangs (3) von der Laserstrahlungsquelle (1) wegzubewegen.

Unter Aufweiten der Abstände zwischen den zumindest drei Teilstrahlen wird im Sinne der Erfindung verstanden, dass sich der Winkel der jeweiligen Teilstrahlen zur optischen Achse des von der Laserstrahlungsquelle (1) emittierten Laserstrahls vergrößert.

Das Aufweiten und die dadurch erfolgende Umlenkung der Teilstrahlen hat den Vorteil, dass die Teilstrahlen durch das Fokussierelement (4) stärker gebündelt werden können. Somit ergibt sich eine höhere Intensität in dem Bereich, in dem die zumindest drei Teilstrahlen auf der Oberfläche oder im Inneren des Substrats (5), bevorzugt flächigen und/oder transparenten Substrats, interferieren.

Durch die geeignete Wahl des Umlenkelements kann auf eine Einheit zur Kontrolle der Intensität des Laserstrahls verzichtet werden. In einer bevorzugten Ausgestaltung der Vorrichtung wird ein Umlenkelement (7) verwendet, dass durch die Aufweitung der zumindest drei Teilstrahlen das Fokussieren der zumindest drei Teilstrahlen auf dem Substrat (5) mittels eines Fokussierelements (4) erlaubt, wobei die Intensität der Interferenzpunkte auf der Oberfläche oder im Inneren des Substrats, bevorzugt flächigen und/oder transparenten Substrats, ohne eine zusätzliche Einstellung der Intensität der Laserstrahlungsquelle (1) erreicht werden kann. Dies hat den Vorteil, dass zur Strukturierung des Substrates unter Erzeugen der periodischen Punktstruktur auch Laserstrahlungsquellen mit niedriger Intensität

*Weiteres Umlenkelement (6)*

Des Weiteren kann vorgesehen sein, dass im Strahlengang (3) der Laserstrahlungsquelle (1) dem Strahlteilerelement (3) nachgeordnet ein weiteres Umlenkelement (6) angeordnet ist, das die Teilstrahlen derart umlenkt, dass sie nach Austritt aus dem weiteren Umlenkelement (6) im Wesentlichen parallel zueinander verlaufen. Dadurch kann die Vorrichtung derart eingerichtet sein, dass der Bearbeitungspunkt, also der Punkt in dem die zumindest drei Teilstrahlen auf der Oberfläche oder im Inneren des Substrats, bevorzugt flächigen und/oder transparenten Substrats, interferieren, bei Verschiebung des Strahlteilerelements im Strahlengang des Lasers entlang seiner optischen Achse konstant bleibt. Unter dem Begriff "im Wesentlichen parallel" soll im Rahmen dieser Schrift ein Winkelversatz von zwischen +15° und -15°, insbesondere lediglich von zwischen +10° und - 10°, ganz besonders bevorzugt von zwischen +5° und -5° zwischen den beiden Teilstrahlen, insbesondere aber natürlich sehr geringer Winkelversatz, also +1° bis -1°, verstanden werden. Idealerweise beträgt der Winkelversatz 0°, wobei geringe Abweichungen aufgrund von Fertigungstoleranzen der optischen Elemente möglich sind.

Das weitere Umlenkelement (6) kann eine konventionelle, refraktive Linse sein. Alternativ kann das weitere Umlenkelement (6) aber auch als diffraktive Linse (z. B. Fresnel-Linse) ausgestaltet sein. Diffraktive Linsen haben den Vorteil, dass diese wesentlich dünner und leichter sind, was eine Miniaturisierung der hierin offenbarten Vorrichtung vereinfacht.

Durch geeignete Auswahl der Brechungsindices der optischen Elemente (4), (6) und (7) können die Abstände zwischen optischen Elementen und Substrat, sowie die Strukturperiode $\Lambda$ eingestellt werden. Alle optischen Elemente mit Ausnahme des Strahlteilerelements (2) können vorzugsweise innerhalb des Strahlengangs (3) des Lasers fixiert sein. Diese besonders bevorzugte Ausführungsform bietet daher den Vorteil, dass zur Anpassung des Interferenzbereichs oder des Interferenzzwinkels lediglich ein Element, nämlich das Strahlteilerelement (2), bewegt werden muss. Das erspart Arbeitsschritte bei der Einrichtung der Vorrichtung, wie Kalibrierung der Vorrichtung auf die gewünschte Strukturperiode. Des Weiteren beugt eine fixe Einstellung, d.h. wobei vorzugsweise alle optischen Elemente innerhalb des Strahlengangs (3) des Lasers fixiert sind, der optischen Elemente deren Verschleiß vor.

*Polarisationselement (8)*

In einer weiteren Ausführungsform befindet sich hinter dem Umlenkelement, besonders bevorzugt in einem Aufbau mit zwei Umlenkelementen (6), (7) hinter dem weiteren Umlenkelement (6), und vor dem Fokussierelement (4) in zumindest einem der Strahlengänge der zumindest 3 Teilstrahlen je ein Polarisationselement (8). Die Polarisationselemente können die Polarisation der Teilstrahlen zueinander modifizieren. Dadurch lässt sich das resultierende Interferenzmuster, das die zumindest 3 Teilstrahlen auf der Oberfläche oder im Volumen eines Substrats, bevorzugt flächigen und/oder transparenten Substrats, abbilden, modifizieren. Durch die Anordnung eines Polarisationselement (8) in zumindest einem der Strahlengänge der Teilstrahlen, vorzugsweise nicht in jedem Strahlengang der Teilstrahlen, vorzugsweise in einem Strahlengang bis (n-1) Strahlengängen, wobei n die Anzahl der erzeugten Teilstrahlen im Applikationsverfahren, kann vorteilhaft die Polarisationsebene zumindest eines Teilstrahls im Strahlengang gedreht und somit das Muster eines Interferenzpixels in der Ebene des Substrates "gestört" werden.

Insbesondere können somit die interferierenden Teilstrahlen nicht polarisiert, linear polarisiert, zirkular polarisiert, elliptisch polarisiert, radial polarisiert oder azimutal polarisiert sein.

*Optisches Element zur Strahlformung*

In einer weiteren Ausgestaltung besitzt die Laserstrahlungsquelle (1) ein Strahlungsprofil, das einem Gauß-Profil, wie oben beschrieben, entspricht. In einer solchen Ausführungsform kann sich hinter der Laserstrahlungsquelle (1) und vor dem Strahlteilerelement (2) ein weiteres optisches Element zur Strahlformung befinden. Dieses Element dient dazu, das Strahlungsprofil der Laserstrahlungsquelle einem Top-Hat-Profil anzugleichen.

Es kann in der erfindungsgemäßen Vorrichtung auch ein optisches Element mit einer konkav parabolisch oder planar reflektierenden Oberfläche vorgesehen sein, wobei das optische Element beispielsweise um mindestens eine Achse drehbar oder entlang des Strahlengangs (3) verschiebbar ausgebildet ist. Hierdurch kann gegebenenfalls auf ein zusätzliches im Strahlengang (3) positioniertes Fokussierelement (4) bzw. ein weiteres Umlenkelement (6) verzichtet werden. Beispielsweise können durch dieses optische Element Laserstrahlen oder Teillaserstrahlen auf die Oberfläche des Fokussierelements (4) oder ein weiteres fokussierendes optisches Element gerichtet werden, bevor die Strahlen zur Ausbildung von Strukturelementen das zu strukturierende Substrat erreichen.

Alternativ kann beispielsweise auch zumindest ein optisches Element mit einer konkav parabolisch oder planar reflektierenden Oberfläche vorgesehen sein, welches beispielsweise um mindestens eine Achse drehbar oder entlang des Strahlengangs (3) verschiebbar ausgebildet ist, wobei dieses optische Element dem ersten Umlenkelement (7) und dem weiteren Umlenkelement (6) im Strahlengang nachgeordnet positioniert ist. So können beispielsweise die Teilstrahlen im Strahlengang umgelenkt werden (Umlenkspiegel) oder derart im Strahlengang fokussiert werden, dass das zu strukturierende Substrat während der Bearbeitung ortsfest positioniert sein kann (sog. Fokussierspiegel bzw. Galvo-Spiegel (Laserscanner) (9)).

Ebenfalls denkbar ist auch eine Ausführungsform, welche einen Polygonscanner umfasst. In dieser Ausgestaltung umfasst zumindest ein optisches Element ein sich periodisch drehendes Prisma, bevorzugt ein sich periodisch drehendes Spiegelprisma, insbesondere einen Polygonspiegel oder auch Polygonrad, sowie ein dem sich periodisch drehenden Prisma im Strahlengang nachgeordnetes Fokussierelement (4). Das Fokussierelement ist derart eingerichtet, dass es die Teilstrahlen derart durchlaufen, dass die Teilstrahlen auf der Oberfläche oder im Inneren eines zu strukturierenden Substrats (5) in einem Interferenzbereich interferieren. In einer bevorzugten Ausgestaltung umfasst das optische Element weiterhin zumindest weiteres Umlenkelement, beispielsweise ein reflektierendes Umlenkelement zum Umlenken der Teilstrahlen im Strahlengang. Das zumindest eine weitere Umlenkelement kann dem sich periodisch drehenden Prisma im Strahlengang vor- und/oder nachgeordnet sein. Das zumindest eine weitere Umlenkelement ist dem Fokussierelement im Strahlengang vorgeordnet.

Ein solcher Aufbau erlaubt vorteilhaft das schnelle Abtasten einer Oberfläche eines Substrats, sodass eine hohe Strukturierungsrate von bis zu 3 m$^2$/min, insbesondere im Bereich von 0,05 bis 2 m$^2$/min, besonders bevorzugt im Bereich von 0,1 bis 1 m$^2$/min, ganz besonders bevorzugt im Bereich von 0,1 bis 0,9 m$^2$/min erreichbar ist. Die genaue Strukturierungsrate ist dabei insbesondere von der verfügbaren Laserleistung abhängig. Mit zukünftigen Technologien, welche eine höhere Laserleistung aufweisen, sind demzufolge noch höhere Strukturierungsraten erreichbar.

## Haltevorrichtung für das Substrat

In einer weiteren Ausgestaltung ist das Substrat (5), bevorzugt flächige und/oder transparente Substrat, in der xy-Ebene beweglich. Durch Bewegung des Substrats (5), bevorzugt flächigen und/oder transparenten Substrats, in der xy-Ebene kann eine flächige Bearbeitung mittels Laserinterferenzstrukturierung gewährleistet werden. Dabei wird in jedem Bearbeitungsschritt (d.h. Laserpuls, der auf das zu strukturierende Substrat trifft) ein Interferenzpixel (wie hierin definiert) erzeugt, der eine Größe D abhängig vom Einfallswinkel und der Intensitätsverteilung des Laserstrahls, sowie den Fokussierungseigenschaften der optischen Elemente besitzt. Der Abstand zwischen den verschiedenen Interferenzpixeln, die Pixeldichte Pd, wird durch die Wiederholrate der Laserstrahlungsquelle (1), sowie der Bewegung des Substrats in Relation zum Fokussierpunkt der optischen Elemente, also dem Punkt, in welchem der Interferenzbereich auf der Oberfläche oder im Inneren des Substrats erzeugt wird, bestimmt. Ist die Pixeldichte Pd kleiner als die Größe der Interferenzpixel D, so ist eine flächige, homogene Bearbeitung möglich.

Durch das Bewegen des Substrats in Relation zum Fokussierpunkt (welcher das Interferenzpixel erzeugt) in Kombination mit gepulsten Laser(teil-)strahlen kann somit eine flächige, optional homogene und periodische, Punktstruktur auf der Oberfläche oder im Inneren eines Substrats, bevorzugt flächigen und/oder transparenten Substrats, erzeugt werden.

Alternativ zum Bewegen des Substrats in Relation zum Fokussierpunkt kann auch der Fokussierpunkt (bspw. durch scannerbasierte Methoden) über die Probe bzw. das Substrat geführt werden.

Eine Verschiebung des zu strukturierenden Substrates, bevorzugt flächigen und/oder transparenten Substrats, im Laserstrahl kann aufgrund der relativ großen dabei bewegten Massen vergleichsweise aufwändig und langsam sein. Es ist daher vorteilhaft das Substrat, bevorzugt flächige und/oder transparente Substrat während der Bearbeitung ortsfest vorzusehen und die flächige Strukturierung des Substrates dadurch zu realisieren, dass die Fokussierung der Teilstrahlen auf die Oberfläche oder das Volumen des Substrats durch Manipulation der Laserteilstrahlen mit optischen Elementen (Fokussierspiegel bzw. Galvo-Spiegel (Laserscanner)) in Strahlrichtung bewirkt wird. Da die dabei bewegten Massen relativ klein sind, ist dies mit weit geringerem Aufwand bzw. viel schneller möglich. Vorzugsweise ist das Substrat während des Verfahrens ortsfest angeordnet.

## Verfahren

Von der vorliegenden Erfindung ist auch ein Verfahren zur Herstellung eines Substrats, bevorzugt flächigen und/oder transparenten Substrats, mit einer periodischen Punktstruktur im Mikro- oder Submikrometerbereich mittels Laserinterferenzstrukturierung mitumfasst.

Im Sinne der Erfindung umfasst das Verfahren zur Herstellung eines strukturierten Substrats, bevorzugt flächigen und/oder transparenten Substrats, mit einer periodischen Punktstruktur im Mikro- oder Submikrometerbereich mittels Laserinterferenzstrukturierung, die folgenden Schritte:
Es wird ein Substrat (5), bevorzugt flächiges und/oder transparentes Substrat, bereitgestellt, welches sich auf einer Haltevorrichtung befindet. Von einer Laserstrahlungsquelle (1) wird ein Laserstrahl emittiert. Der Laserstrahl wird durch ein Strahlteilerelement (2) und zumindest drei, besonders bevorzugt vier Teilstrahlen geteilt. Die Teilstrahlen treffen auf ein Fokussierelement (4) auf, welches die zumindest drei, besonders bevorzugt vier Teilstrahlen auf der Oberfläche oder im Inneren des Substrats (5), bevorzugt flächigen und/oder transparenten Substrats, fokussiert (bündelt), sodass die Teilstrahlen auf der Oberfläche oder im Inneren des Substrats konstruktiv und destruktiv interferieren. Somit wird eine periodische Punktstruktur im Mikro- oder Submikrometerbereich auf der Oberfläche oder im Inneren des Substrats (5), bevorzugt flächigen und/oder transparenten Substrats, durch Laserinterferenzbearbeitung erzeugt. Das Verfahren ist dadurch gekennzeichnet, dass die zumindest drei Teilstrahlen so überlagert werden, dass ein 2D-Muster entsteht.

Nach einer weiteren Ausgestaltung der Erfindung wird der Laserstrahl durch das Strahlteilerelement in zumindest 2 Teilstrahlen unterteilt. Die Teilstrahlen treffen auf ein Fokussierelement (4) auf, welches die zumindest drei, besonders bevorzugt vier Teilstrahlen auf der Oberfläche oder im Inneren des Substrats (5), bevorzugt flächigen und/oder transparenten Substrats, fokussiert (bündelt), sodass die Teilstrahlen auf der Oberfläche oder im Inneren des Substrats konstruktiv und destruktiv interferieren. Somit wird eine periodische Punktstruktur im Mikro- oder Submikrometerbereich auf der Oberfläche oder im Inneren des Substrats (5), bevorzugt flächigen und/oder transparenten Substrats, durch Laserinterferenzbearbeitung erzeugt. Das Verfahren ist dadurch gekennzeichnet, dass die zumindest drei Teilstrahlen so überlagert werden, dass ein 1D-Muster, insbesondere ein Linienmuster, entsteht.

Dabei sind die so erzeugten Punktstrukturen in Form als periodisch angeordnete, inverse Zapfen ausgebildet, wobei der Abstand zwischen den Scheitelpunkt (d.h. Höhenmittelpunkt oder Zentren der Erhebungen) im statistischen Mittel im Bereich von 50 nm bis 50 $\mu$m, bevorzugt im Bereich von 50 nm bis 20 $\mu$m, besonders bevorzugt im Bereich von 100 nm bis 4 $\mu$m, mehr bevorzugt im Bereich von 100 nm bis 2 $\mu$m, noch mehr bevorzugt im Bereich von 200 nm bis 1,5 $\mu$m, ganz besonders bevorzugt im Bereich von 300 nm bis 800 nm.

Die Erfinder der vorliegenden Erfindung haben darüber hinaus herausgefunden, dass neben der Periodizität auch die Strukturtiefe (d.h. die Tiefe der inversen Zapfen, gemessen von deren Sattelpunkt der Vertiefung bis zum Scheitelpunkt) bzw. Profiltiefe einen Einfluss auf die Antireflexionseigenschaften (wie hierin definiert) haben. Beispielsweise liegt die Strukturtiefe bzw. Profiltiefe der inversen Zapfen (Erhebungen und Vertiefungen) im statistischen Mittel im Bereich von 5 nm bis 500 nm, bevorzugt im Bereich von 5 nm bis 300 nm, ganz besonders bevorzugt im Bereich von 5 nm bis 100 nm, noch mehr bevorzugt im Bereich von 5 nm bis 75 nm. Die Strukturtiefe der inversen Zapfen eines Interferenzpixels wird im Allgemeinen durch die mittleren Strukturtiefe ($d_{50}$) beschrieben, die innerhalb eines Interferenzpixels die 50% Anteile der Zapfen mit einer bestimmten Strukturtiefe kleiner oder größer als der angegebene Wert für die Strukturtiefe definiert.

Nach einer bevorzugten Ausgestaltung der vorliegenden Erfindung weisen die inversen Zapfen eine Strukturtiefe im Bereich von 5 nm bis 200 nm, besonders bevorzugt im Bereich von 5 nm bis 150 nm, ganz besonders bevorzugt 10 nm bis 100 nm auf.

Bevorzugt wird eine Vorrichtung zur Herstellung eines strukturierten Substrats (5), bevorzugt flächigen und/oder transparenten Substrats, genutzt, die zwei Umlenkelemente (6), (7) umfasst. Die Umlenkelemente (6), (7) sind im Strahlengang (3) des Lasers zwischen dem Strahlteilerelement (2) und dem Fokussierelement (4) angeordnet. Die Umlenkelemente (6), (7) dienen zur Aufweitung des Diffraktionswinkels der zumindest drei, besonders bevorzugt vier Teilstrahlen, in dem sie auf der Oberfläche oder im Inneren des Substrats (5), bevorzugt flächigen und/oder transparenten Substrats, interferieren. Durch die Einstellung der Abstände der optischen Elemente kann gewährleistet werden, dass zur Veränderung der Strukturperiode lediglich das Strahlteilerelement (2) entlang seiner optischen Achse beweglich sein muss. Dies ermöglicht leichtere Einstellprozesse während der Bearbeitung.

In einer besonders bevorzugten Ausführungsform wird als flächiges Substrat ein transparentes Material zur Verfügung gestellt. Durch die Lichtdurchlässigkeit des transparenten Materials ist eine Laserinterferenzbearbeitung, vorzugsweise mit einer Ausführungsform der oben genannten Vorrichtung im Innern des Substrats möglich.

In einer bevorzugten Ausführungsform wird eine Vorrichtung zur Herstellung eines strukturierten Substrats, bevorzugt flächigen und/oder transparenten Substrats, genutzt, die eine gepulste Laserstrahlungsquelle (1) verwendet. In einer besonders bevorzugten Ausführungsform wird eine Vorrichtung zur Herstellung eines strukturierten Substrats, bevorzugt flächigen und/oder transparenten Substrats, genutzt, die über eine Haltevorrichtung für das Substrat verfügt, die in der xy-Ebene, senkrecht zum Strahlengang (3) des von der Laserstrahlungsquelle (1) emittierten Laserstrahls frei beweglich ist.

Über die Frequenz der Laserstrahlungsquelle (1), f, und die Geschwindigkeit der Bewegung der Haltevorrichtung, v, lässt sich die Pixeldichte Pd, also der Abstand in der ein Interferenzpixel mit der Weite D auf dem Substrat, bevorzugt flächigen und/oder transparenten Substrat, aufgebracht werden kann, einstellen zu:

$$Pd = {}^{v}\!/_{f}$$

Ist die Weite des Interferenzpixels, D, größer als die Pixeldichte Pd, so überlagern sich benachbarte Interferenzpixel in einem Bereich. Dieser Bereich ist dem Fachmann als Pulsüberlapp, OV, bekannt. Er kann berechnet werden zu:

$$OV = {}^{(D - Pd)}\!/_{D}$$

In einer bevorzugten Ausgestaltung ist bei dem Verfahren zur Herstellung eines strukturierten Substrats, bevorzugt flächigen und/oder transparenten Substrats, Pd kleiner als D. Der dadurch entstehende Pulsüberlapp OV führt zu einer Mehrfachbestrahlung des Substrats, bevorzugt flächigen und/oder transparenten Substrats. Bevorzugt können so nicht-texturierte Flächen vermieden werden.

In einer besonders bevorzugten Ausgestaltung werden bei dem Verfahren zur Herstellung eines strukturierten Substrats, bevorzugt flächigen und/oder transparenten Substrats dieselben Interferenzpixel mehrfach bestrahlt. Dadurch ist es möglich, die Tiefe der entstandenen Mikrostrukturen zu erhöhen.

Der Vorteil eines durch ein solches Verfahren erzeugten strukturierten Substrats, bevorzugt flächigen und/oder transparenten Substrats ist die hohe Regelmäßigkeit der erzeugten periodischen Punktstrukturen mit Strukturabmessungen im Mikro- oder Submikrometerbereich. Eine so erzeugte periodische Punktstruktur mit Abmessungen im Mikro- oder Submikrometerbereich hat vorzugsweise einen Variationskoeffizienten (ein Wert, der sich aus der Teilung der Standardabweichung durch den Durchschnittswert ergibt) des Zapfenquerschnitts von 15% oder weniger, mehr bevorzugt 10% oder weniger, noch mehr bevorzugt 5% oder weniger.

Insbesondere eignet sich die Mehrfachbestrahlung eines Substrats zur Herstellung von hierarchischen Strukturen. So bewirkt die Mehrfachbestrahlung desselben Interferenzpixels ein zumindest teilweises Aufschmelzen des Substratmaterials, wobei sich während des Strukturierungsprozesses, d.h. beim Auftreffen eines Laserpulses, als Folge des Auftretens eines Bereiches hoher Intensität eine Wellenstruktur ausbildet. Dabei bildet sich die Strukturierung, insbesondere die Wellenstruktur durch einen Selbstorganisationsprozess aus. Insbesondere überlagert die Wellenstruktur eine periodische Punktstruktur im Mikro- oder Submikrometerbereich, welche mittels Laserinterferenzstrukturierung erzeugbar ist. Somit ist mit einem Verfahrensschritt eine hierarchische Strukturierung in einem Substrat erzeugbar. Nach einer bevorzugten Ausgestaltung der Erfindung erfolgt daher die Mehrfachbestrahlung, vorzugsweise 2-fache bis 400-fache, insbesondere 20-fache bis 300-fache, besonders bevorzugt 50-fache bis 200-fache Bestrahlung desselben Interferenzpixels auf dem Substrat, wodurch eine Wellenstruktur (wie hierin definiert) ausgebildet wird, insbesondere eine periodische Punktstruktur aus sich überlagernden Strukturen ausgebildet wird, wobei mindestens eine Struktur Abmessungen im Submikrometerbereich, insbesondere eine quasi-periodische Wellenstruktur aufweist, und wobei zumindest eine Struktur aus inversen Zapfen gebildet ist. Besonders bevorzugt ist der Zeitversatz zwischen den einzelnen Pulsen dabei im Bereich der Pulsdauer des Laserpulses, bevorzugt im Bereich von 1 fs bis 100 ns, besonders bevorzugt im Bereich von 10 fs bis 10 ns, ganz besonders bevorzugt im Bereich von 10 fs bis 15 ps.

Dabei bezeichnet eine hierarchische Strukturierung eine Struktur, bei welcher eine erste Struktur mit Abmessungen im Mikro- oder Submikrometerbereich, welche einem Interferenzmuster entspricht, von einer weiteren Struktur überlagert ist, welche Abmessungen aufweist, die unterhalb der Abmessungen der ersten Struktur liegen und welche durch einen Selbstorganisationsprozess ausgebildet ist. Bevorzugt befinden sich die Abmessungen der weiteren Struktur, welche durch einen Selbstorganisationsprozess ausgebildet ist, im Bereich von 1% bis 30% der Abmessungen der ersten Struktur, welche einem Interferenzmuster entspricht.

Für hierarchische Strukturen gibt es zahlreiche technische Anwendungsgebiete, wie bspw. im Bereich der Herstellung von Substraten mit hydrophoben oder superhydrophoben sowie hydrophilen oder superhydrophilen Oberflächen und Substrate mit Anti-Icing, oder Anti-Fogging Eigenschaften neben den eingangs genannten Substraten mit Antireflexionseigenschaften. Vorteilhaft ermöglicht ein Verfahren zur Herstellung solcher hierarchischer Strukturen, wie hierin beschrieben, das präzise Einstellen der Prozessparameter für die Strukturabmessungen durch eine geeignete Auswahl der Laserstrahlungsquelle und ein entsprechendes Verschieben des Strahlteilerelements im Strahlengang des Lasers.

Zusätzlich ist es durch das hierin definierte Verfahren möglich, mittels derselben Vorrichtung und darüber hinaus im selben Prozessschritt ein Substrat mit hierarchischen Strukturen zu versehen, während herkömmliche Prozesse sukzessiv vorgehen, d.h. nicht in der Lage sind, zeitgleich welcher eine erste Struktur mit Abmessungen im Mikro- oder Submikrometerbereich, welche einem Interferenzmuster entspricht, und eine weitere Struktur, welche durch einen Selbstorganisationsprozess ausgebildet ist, zu erzeugen.

Eine Verschiebung des zu strukturierenden Substrates, bevorzugt flächigen und/oder transparenten Substrats, im Laserstrahl ist aufgrund der relativ großen dabei bewegten Massen vergleichsweise aufwändig und langsam. Es ist daher vorteilhaft das Substrat, bevorzugt flächigen und/oder transparenten Substrats während der Bearbeitung ortsfest vorzusehen und die flächige Strukturierung des Substrates dadurch zu realisieren, dass die Fokussierung der Teilstrahlen auf die Oberfläche oder das Volumen des Substrats durch Manipulation der Laserteilstrahlen mit optischen Elementen (Fokussierspiegel bzw. Galvo-Spiegel (Laserscanner)) in Strahlrichtung bewirkt wird. Da die dabei bewegten Massen relativ klein sind, ist dies mit weit geringerem Aufwand bzw. viel schneller möglich. Vorzugsweise ist das Substrat während des Verfahrens ortsfest angeordnet.

Die flächige Strukturierung des Substrates ist selbstverständlich grundsätzlich auch durch eine Verschiebung des Substrates im Laserstrahl möglich.

Durch die mittels des hierin offenbarten Verfahrens und der Vorrichtung erzeugten periodischen Strukturen im Mikro- und/oder Nanometerbereich weist das derart strukturierte Substrat Antireflexionseigenschaften auf. Dies wird dadurch gewährleistet, dass Licht, das auf das Substrat eintrifft, weniger reflektiert bzw. unter einem so flachen Winkel reflektiert, dass es bei normaler Betrachtung der Materialoberfläche nicht "störend" wirkt.

Von der Erfindung ist daher auch ein strukturiertes Substrat mit Antireflexionseigenschaften erfasst, das eine periodische Punktstruktur im Mikro- oder Submikrometerbereich umfasst, wobei die periodische Punktstruktur aus inversen Zapfen gebildet ist, wobei die inversen Zapfen periodisch mit einem Abstand bezogen auf deren Sattelpunkt bzw. Mittelpunkt im Bereich von 50 nm bis 50 µm bevorzugt im Bereich von 50 nm bis 20 µm, besonders bevorzugt im Bereich von 100 nm bis 4 µm, mehr bevorzugt im Bereich von 100 nm bis 2 µm, noch mehr bevorzugt im Bereich von 200 nm bis 1,5 µm, mehr bevorzugt im Bereich von 100 nm bis 1.000 nm, ganz besonders bevorzugt im Bereich von 300 nm bis 800 nm zueinander angeordnet sind.

Nach einer bevorzugten Ausgestaltung der Erfindung, wird das strukturierte Substrat durch Bearbeitung mit einem Verfahren, wie hierin definiert, erhalten.

Die vorliegende Erfindung betrifft auch ein Verfahren zum zur Herstellung eines Substrats mit einer periodischen Punktstruktur im Mikro- oder Submikrometerbereich mittels Laserinterferenzstrukturierung, insbesondere durch ein hierin offenbartes Verfahren, umfassend die folgenden Schritte:

a) Applizieren eines ersten Pulses auf der Oberfläche eines Substrates (5), vorzugsweise durch eine Vorrichtung wie hierin definiert, der ein erstes Interferenzpixel auf der Oberfläche des Substrates (5) oder in dem Substrat (5) generiert,

b) Applizieren eines zweiten Pulses auf der Oberfläche eines Substrates (5), vorzugsweise durch eine Vorrichtung wie hierin definiert, der ein zweites Interferenzpixel auf Oberfläche des Substrates (5) oder in dem Substrat (5) generiert,

wobei das erste und das zweite Interferenzpixel jeweils unabhängig voneinander eine periodische Punktstruktur mit Abmessungen im Mikro- und Submikrometer Bereich umfassen,

dadurch gekennzeichnet, dass der Versatz zwischen dem zweiten Interferenzpixel und dem ersten Interferenzpixel im Bereich von 10% $\leq$ x $\leq$ 50% der Interferenzperiode liegt.

Besonders vorteilhaft kann hierdurch auf dem Substrat, insbesondere auf einem transparenten Substrat eine Strukturierung erzeugt werden, die Anti-Glare Eigenschaften aufweist.

Unter Glare (Blendung) versteht man im Sinne der Erfindung die Reflexion des Lichts einer Lichtquellequelle (z. B. der Sonne) auf einem transparenten Substrat, bspw. einem Fenster oder einem Bildschirm, wodurch es schwierig werden kann, das Geschehen auf dem Bildschirm zu erkennen.

Mit Hilfe einer Anti-Glare-Behandlung der Oberflächen (im Stand der Technik typischerweise durch Beschichtungen erzeugt) können diese Blendeffekte reduziert werden. Eine Anti-Glare Struktur streut auftreffendes Licht an der Oberfläche, so dass eine Spiegelung deutlich reduziert werden kann.

Nach einer bevorzugten Ausgestaltung der Erfindung sind die Periode der Punktstruktur des ersten Interferenzpixels und die Periode des zweiten Interferenzpixels identisch.

Darüber hinaus kann vorgesehen sein, dass nach Schritt b) ein dritter Puls auf der Oberfläche eines Substrates (5), vorzugsweise durch eine Vorrichtung wie hierin definiert, appliziert wird, wobei das dritte Interferenzpixel eine periodische Punktstruktur mit Abmessungen im Mikro- und Submikrometer Bereich umfassen, wobei der dritte Puls ein drittes Interferenzpixel auf der Oberfläche des Substrates (5) oder in dem Substrat (5) generiert, wobei der dritte Interferenzpixel im Bezug zum zweiten Interferenzpixel einen Versatz im Bereich von 10% $\leq$ x $\leq$ 50% der Interferenzperiode aufweist,

Verfahren nach Anspruch 17 oder 18, wobei der Versatz der Interferenzperiode in zumindest einer Raumrichtung gleichmäßig ausgebildet ist.

## Strukturiertes Substrat

Die Erfinder haben herausgefunden, dass sich Substrate, die vornehmlich durch eine hierin offenbarte Vorrichtung oder ein hierin offenbartes Verfahren strukturiert wurden, durch ausgeprägte Antireflexionseigenschaften auszeichnen. Die vorliegende Erfindung betrifft daher auch ein strukturiertes Substrat mit Antireflexionseigenschaften, wie hierin definiert, das eine periodische Punktstruktur im Mikro- oder Submikrometerbereich umfasst, wobei die periodische Punktstruktur insbesondere aus einer inversen Zapfenstruktur (hierin auch als inverse Zapfen bezeichnet) gebildet ist, wobei die inversen Zapfen periodisch mit einem Abstand bezogen auf deren Sattelpunkt bzw. Mittelpunkt im Bereich von 50 nm bis 50 µm, bevorzugt im Bereich von 50 nm bis 20 µm, besonders bevorzugt im Bereich von 100 nm bis 4 µm, mehr bevorzugt im Bereich von 100 nm bis 2 µm, noch mehr bevorzugt im Bereich von 200 nm bis 1,5 µm, mehr bevorzugt im Bereich von 100 nm bis 1.000 nm ganz besonders bevorzugt im Bereich von 300 nm bis 800 nm.

Die so erzeugte periodische Punktstruktur hat die Eigenschaft, dass abhängig von ihrer Strukturabmessung einstrahlende elektromagnetische Strahlung mit Wellenlängen im Bereich von 10 nm bis 1 mm vermehrt transmittiert, beziehungsweise durch die periodischen Strukturen gebeugt werden können, sodass eine verringerte Reflexion an der Oberfläche des Substrats resultiert. Ist die Periode der erzeugten periodischen Punktstrukturen im Bereich der Wellenlänge der einfallenden elektromagnetischen Welle, so wird diese an der Oberfläche des Substrates gebeugt. Ist die Periode der erzeugten periodischen Punktstruktur kleiner als die Wellenlänge der einfallenden elektromagnetischen Welle, so wird diese transmittiert.

Die periodische Punktstruktur ist dabei vorzugsweise derart ausgebildet, dass das strukturierte Substrat bei einer periodische Punktstruktur von weniger als 1.000 nm elektromagnetische Strahlung mit einer Wellenlänge von mehr als 550 nm, bevorzugt bei einer periodische Punktstruktur von weniger als 750 nm von mehr als 500 nm, ganz besonders bevorzugt bei einer periodische Punktstruktur von weniger als 600 nm von mehr als 450 nm transmittiert. In Abhängigkeit der Strukturtiefe der inversen Zapfen können somit insbesondere Wellenlängen im roten und/oder gelben Lichtspektrum, im grünen Lichtspektrum bis hin ins blaue Lichtspektrum in das Substrat transmittieren.

Der Brechungsindex des strukturierten Substrats ist durch die erzeugte periodische Punktstruktur graduell. Er nimmt über die Höhe der Struktur hinweg ab, sodass kein klarer Luft-Medium Übergang existiert. Dadurch kommt es zur erhöhten Transmission von einfallenden elektromagnetischen Wellen mit einer Wellenlänge größer als die Strukturperiode der erzeugten Punktstruktur, und zur Beugung von einfallenden elektromagnetischen Wellen mit einer Wellenlänge im Bereich der Strukturperiode der erzeugten Punktstruktur.

Aufgrund der erzeugbaren, sehr geringen Strukturabmessungen eignen sich die hierin offenbarte Vorrichtung und das hierin offenbarte Verfahren zur Herstellung einer Antireflexionsstruktur ebenfalls zum Erzeugen von Oberflächen mit hydrophoben und/oder superhydrophoben sowie hydrophilen und/oder superhydrophilen Eigenschaften.

Hydrophobe Eigenschaften hängen sowohl von der chemischen als auch von der Oberflächenbeschaffenheit, insbesondere der Oberflächenrauigkeit, eines Substrats ab. Die Erfinder haben nun überraschend herausgefunden, dass sich durch das erfindungsgemäße Verfahren insbesondere hydrophobe Substrate durch das Einbringen von Strukturierungen im Mikrometer- und Submikrometerbereich, insbesondere sich überlagernden Strukturen (wie hierin definiert) Substratoberflächen erhalten werden, die superhydrophobe und selbstreinigende Eigenschaften aufweisen. Besonders bevorzugt handelt es sich bei Substraten mit superhydrophoben Eigenschaften um Substrate mit einer hierarchischen Oberflächenstrukturierung. Unter einer hierarchischen Oberflächenstrukturierung ist hierin zu verstehen, dass es sich um eine Oberfläche handelt, auf der sich regelmäßige Strukturen mit Abmessungen im Mikrometerbereich befinden, welche wiederum ihrerseits an ihrer Oberfläche eine Strukturierung mit Abmessungen im Submikrometerbereich aufweisen. Eine solche hierarchische Strukturierung kann zu einer hohen Oberflächenrauigkeit führen.

Die Erfinder haben zudem herausgefunden, dass sich Substrate, die vornehmlich durch eine hierin offenbarte Vorrichtung oder ein hierin offenbartes Verfahren strukturiert wurden, durch ausgeprägte hydrophobe Eigenschaften an der Oberfläche eines Substrats auszeichnen. Mittels der hierin offenbarten Vorrichtung und des Verfahrens zur Erzeugung von Antireflexionsstrukturen mit Abmessungen im Mikro- und Submikrometerbereich ist auch eine Strukturierung zur Erzeugung von einer Oberflächenbeschaffenheit, insbesondere einer Oberflächenrauigkeit auf der Oberfläche eines Substrats möglich, welche dazu führt, dass das Substrat hydrophobe oder superhydrophobe Eigenschaften aufweist. Hydrophobe Materialeigenschaften können erzeugt werden, indem mittels der direkten Laserinterferenzstrukturierung eine Struktur mit Abmessungen im Mikro- und/oder Submikrometerbereich erzeugt wird. In einer bevorzugten Ausführung wird zunächst eine Struktur mit Abmessungen im Mikrometerbereich an der Oberfläche erzeugt. Danach wird durch Verschieben des Strahlteilerelements im Strahlengang des Lasers eine Struktur mit Abmessungen im Submikrometerbereich auf der Oberfläche der ersten Struktur generiert, wobei vorzugsweise eine Mehrfachbestrahlung des Substrats erfolgt. Die so erzeugte hierarchische Struktur hat hydrophobe oder superhydrophobe Eigenschaften.

Zum Erzeugen eines Substrates mit hydrophoben Eigenschaften ist es ebenfalls denkbar, dass lediglich eine Struktur mit Abmessungen im Mikro- oder Submikrometerbereich erzeugt wird, ohne dass das Strahlteilerelement in einem Zwischenschritt bewegt wird.

Vorteilhaft können somit mittels desselben Verfahrens und auf Basis derselben Vorrichtung in technisch leicht realisierbarer Art und Weise Substrate mit hydrophoben und/oder superhydrophoben Eigenschaften erzeugt werden, indem eine periodische Punktstruktur im Mikro- oder Submikrometerbereich und/oder eine periodische Punktstruktur mit hierarchischer Struktur im Mikro- und Submikrometerbereich erzeugt wird. Durch das Verschieben des Strahlteilerelements ist eine zumindest zweifache, aber auch eine beliebige Anzahl an weiterer Strukturierung auf der Oberfläche des Substrates ohne weitere Veränderung des Aufbaus, bspw. ohne den Austausch von optischen Elementen oder Verschieben des Substrats, realisierbar. Dadurch ist sowohl die Präzision in der Ausrichtung der Strukturen, als auch die Geschwindigkeit des Prozesses gesteigert gegenüber herkömmlichen Verfahren oder Vorrichtungen.

Die Erfinder haben einen Zusammenhang zwischen der Oberflächenbeschaffenheit eines Substrats und der Eisbildung an dessen Oberfläche festgestellt. Insbesondere können demgemäß sog. Anti-Icing Eigenschaften erzeugt werden, wenn die Strukturgröße an der Oberfläche eines Substrates hinreichend klein ist. Forschungsergebnisse haben gezeigt, dass ein Substrat mit superhydrophoben Eigenschaften auch Anti-Icing Eigenschaften aufweisen kann.

Unter Anti-Icing Eigenschaften ist im Sinne der Erfindung zu verstehen, dass an der Oberfläche eines Substrates kein oder nur sehr wenig Wasser gefriert, wobei diese Eigenschaft auf die Oberflächenbeschaffenheit, insbesondere die Oberflächenrauigkeit zurückzuführen ist.

Ein solches Substrat kann vorteilhaft im Bereich der Luft- und Raumfahrt, bei Windturbinen, im Bereich von Automobilkomponenten oder auch Telekommunikations- und Antennentechnik verwendet werden, um exponierte Bestandteile vor Vereisen zu schützen.

Die Erfinder haben weiterhin herausgefunden, dass sich Substrate, die vornehmlich durch eine hierin offenbarte Vorrichtung oder ein hierin offenbartes Verfahren strukturiert wurden, durch ausgeprägte hydrophile Eigenschaften an der Oberfläche eines Substrats auszeichnen. Mittels der hierin offenbarten Vorrichtung und des Verfahrens zur Erzeugung von Antireflexionsstrukturen mit Abmessungen im Mikro- und Submikrometerbereich ist auch eine Strukturierung zur Erzeugung von einer Oberflächenbeschaffenheit, insbesondere einer Oberflächenrauigkeit auf der Oberfläche eines Substrats möglich, welche dazu führt, dass das Substrat hydrophile oder superhydrophile Eigenschaften aufweist.

Hydrophile Materialeigenschaften können erzeugt werden, indem mittels der direkten Laserinterferenzstrukturierung eine Struktur mit Abmessungen im Mikro- und/oder Submikrometerbereich erzeugt wird. In einer bevorzugten Ausführung wird zunächst eine Struktur mit Abmessungen im Mikrometerbereich an der Oberfläche erzeugt. Danach wird durch Verschieben des Strahlteilerelements im Strahlengang des Lasers eine Struktur mit Abmessungen im Submikrometerbereich auf der Oberfläche der ersten Struktur generiert, wobei vorzugsweise eine Mehrfachbestrahlung des Substrats erfolgt. Die so erzeugte hierarchische Struktur hat hydrophile oder superhydrophile Eigenschaften.

Zum Erzeugen eines Substrates mit hydrophilen Eigenschaften ist es ebenfalls denkbar, dass lediglich eine Struktur mit Abmessungen im Mikro- oder Submikrometerbereich erzeugt wird, ohne dass das Strahlteilerelement in einem Zwischenschritt bewegt wird.

Vorteilhaft können somit mittels desselben Verfahrens und auf Basis derselben Vorrichtung in technisch leicht realisierbarer Art und Weise Substrate mit hydrophilen und/oder superhydrophilen Eigenschaften erzeugt werden, indem eine periodische Punktstruktur im Mikro- oder Submikrometerbereich und/oder eine periodische Punktstruktur mit hierarchischer Struktur im Mikro- und Submikrometerbereich erzeugt wird. Durch das Verschieben des Strahlteilerelements ist eine zumindest zweifache, aber auch eine beliebige Anzahl an weiterer Strukturierung auf der Oberfläche des Substrates ohne weitere Veränderung des Aufbaus, bspw. ohne den Austausch von optischen Elementen oder Verschieben des Substrats, realisierbar. Dadurch ist sowohl die Präzision in der Ausrichtung der Strukturen, als auch die Geschwindigkeit des Prozesses gesteigert gegenüber herkömmlichen Verfahren oder Vorrichtungen.

Die Erfinder haben einen Zusammenhang zwischen der Oberflächenbeschaffenheit eines Substrats und der Bildung von Kondenswasser, insbesondere in Form von Beschlag oder Nebel, an dessen Oberfläche festgestellt. Insbesondere können demgemäß sog. Anti-Fogging Eigenschaften erzeugt werden, wenn die Strukturgröße an der Oberfläche eines Substrates hinreichend klein ist. Forschungsergebnisse haben gezeigt, dass ein Substrat mit superhydrophilen Eigenschaften auch Anti-Fogging Eigenschaften aufweisen kann.

Unter Anti-Fogging Eigenschaften ist im Sinne der Erfindung zu verstehen, dass an der Oberfläche eines Substrates kein oder nur sehr wenig Wasser in Form von Tropfen kondensiert, wobei diese Eigenschaft auf die Oberflächenbeschaffenheit, insbesondere die Oberflächenrauigkeit zurückzuführen ist.

Ein solches Substrat kann vorteilhaft im Bereich der Luft- und Raumfahrt, im Bereich von Automobilkomponenten oder auch Telekommunikations- und Antennentechnik verwendet werden, um exponierte Bestandteile vor dem Beschlagen zu schützen.

In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, welche mittels Laserinterferenzstrukturierung erzeugt wurde, umfasst und welches sich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des sichtbaren Lichts, insbesondere mit Wellenlängen im Bereich von 400 nm bis 700 nm. Dabei zeichnet sich das Substrat dadurch aus, dass die von ihm umfasste periodische Punktstruktur vorzugsweise Abmessungen im Submikrometerbereich, besonders bevorzugt im Nanometerbereich aufweist. Ganz besonders bevorzugt sind die Abmessungen der periodischen Punktstruktur im Bereich der Wellenlänge von elektromagnetischer Strahlung im Bereich des sichtbaren Lichts. So sind die Abmessungen der periodischen Punktstruktur bevorzugt im Bereich von 630 nm bis 700 nm zum Transmittieren, bzw. Beugen von rotem Licht, im Bereich von 590 nm bis 630 nm zum Transmittieren, bzw. Beugen von rotem und orangenem Licht, im Bereich von 560 nm bis 590 nm zum Transmittieren, bzw. Beugen von rotem, orangenem und gelben Licht, im Bereich von 500 nm bis 560 nm zum Transmittieren, bzw. Beugen von rotem, orangenem, gelbem und grünem Licht, im Bereich von 475 nm bis 500 nm zum Transmittieren, bzw. Beugen von rotem, orangenem, gelbem, grünem und türkisem Licht, im Bereich von 450 nm bis 475 nm zum Transmittieren, bzw. Beugen von rotem, orangenem, gelbem, grünem, türkisem und blauem Licht, im Bereich von 425 nm bis 450 nm zum Transmittieren, bzw. Beugen von rotem, orangenem, gelbem, grünem, türkisem, blauem und indigofarbenem Licht, im Bereich von 400 nm bis 425 nm zum Transmittieren, bzw. Beugen von rotem, orangenem, gelbem, grünem, türkisem, blauem, indigofarbenem und violettem Licht. Somit lassen sich durch das Verändern der Abmessungen der periodischen Punktstruktur die Antireflexionseigenschaften des Substrats kontrollieren.

In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, welche mittels Laserinterferenzstrukturierung erzeugt wurde, umfasst und welches sich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des nicht sichtbaren Lichts, insbesondere im Bereich von Infrarotstrahlung, bzw. Wärmestrahlung, insbesondere mit Wellenlängen im Bereich von 780 nm bis 1 mm. Dabei zeichnet sich das Substrat dadurch aus, dass die von ihm umfasste periodische Punktstruktur vorzugsweise Abmessungen im Mikrometerbereich aufweist. Vorteilhaft ist so die Wärmetransmission des Substrats durch Verändern der Abmessungen der periodischen Punktstruktur anpassbar.

In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, welche mittels Laserinterferenzstrukturierung erzeugt wurde, umfasst und welches sich durch Antireflexionseigenschaften auszeichnet. Im Sinne der Erfindung beziehen sich Antireflexionseigenschaften hierin auf das vermehrte Transmittieren, bzw. Beugen von einfallender elektromagnetischer Strahlung mit Wellenlängen im Bereich des nicht sichtbaren Lichts, insbesondere im Bereich von Ultraviolettstrahlung (IV-Strahlung), insbesondere mit Wellenlängen im Bereich von 100 nm bis 380 nm. Dabei zeichnet sich das Substrat dadurch aus, dass die von ihm umfasste periodische Punktstruktur vorzugsweise Abmessungen im Nanometerbereich aufweist. Vorteilhaft ist ein so strukturiertes Substrat in Bereichen einsetzbar, in denen ein Schutz vor UV-Strahlung notwendig ist.

In einer weiteren Ausgestaltung der Erfindung eignet sich das hierin offenbarte Verfahren und die hierin offenbarte Vorrichtung zum Erzeugen eines Substrates, welches hierarchische Strukturen, welche mittels Laserinterferenzstrukturierung durch eine Mehrfachbestrahlung desselben Interferenzpixels erzeugt wurden, aufweist, welche sich durch hydrophobe oder superhydrophobe Eigenschaften auszeichnen. Dabei sind die hydrophoben oder superhydrophoben Eigenschaften darauf zurückzuführen, dass Strukturen mit Abmessungen im Mikro- oder Submikrometerbereich, insbesondere hierarchische Strukturen mit Abmessungen im Mikro- und Submikrometerbereich den Benetzungswinkel von Flüssigkeiten auf Substraten derart verändern, dass dieser größer wird. Durch einen größeren Benetzungswinkel ergibt sich, dass auf die Oberfläche auftreffende Flüssigkeiten diese nicht gut benetzen und stattdessen von dieser abperlen. Ein so behandeltes Substrat weist selbstreinigende und wasserabweisende Eigenschaften auf. Besonders geeignete Materialien für ein solches strukturiertes Substrat sind solche Materialien, welche bereits hydrophobe Eigenschaften aufweisen, z.B. Metall- oder Polymeroberflächen.

In einer weiteren Ausgestaltung der Erfindung eignet sich das hierin offenbarte Verfahren und die hierin offenbarte Vorrichtung zum Erzeugen eines Substrates, welches hierarchische Strukturen, welche mittels Laserinterferenzstrukturierung durch eine Mehrfachbestrahlung desselben Interferenzpixels erzeugt wurden, aufweist, welche sich durch Anti-Icing, also dem Bilden von Eisschichten vorbeugende, Eigenschaften auszeichnen. Die Anti-Icing Eigenschaften beruhen dabei darauf, dass Strukturen mit Abmessungen im Mikro- oder Submikrometerbereich, insbesondere hierarchische Strukturen mit Abmessungen im Mikro- und Submikrometerbereich den Benetzungswinkel von Flüssigkeiten auf Substraten derart verändern, dass dieser größer wird. Das strukturierte Substrat weist somit hydrophobe oder superhydrophobe Eigenschaften auf. Durch einen größeren Benetzungswinkel ergibt sich, dass auf die Oberfläche auftreffende Flüssigkeiten diese nicht gut benetzen und stattdessen von dieser abperlen. Somit wird auch das Ablagern von Eisschichten auf der Oberfläche erschwert. Besonders geeignete Materialien für ein solches strukturiertes Substrat sind solche Materialien, welche bereits hydrophobe Eigenschaften aufweisen, z.B. Metall- oder Polymeroberflächen.

In einer weiteren Ausgestaltung der Erfindung eignet sich das hierin offenbarte Verfahren und die hierin offenbarte Vorrichtung zum Erzeugen eines Substrates, welches hierarchische Strukturen, welche mittels Laserinterferenzstrukturierung durch eine Mehrfachbestrahlung desselben Interferenzpixels erzeugt wurden, aufweist, welche sich durch hydrophile oder superhydrophile Eigenschaften auszeichnen. Dabei sind die hydrophilen oder superhydrophilen Eigenschaften darauf zurückzuführen, dass Strukturen mit Abmessungen im Mikro- oder Submikrometerbereich, insbesondere hierarchische Strukturen mit Abmessungen im Mikro- und Submikrometerbereich den Benetzungswinkel von Flüssigkeiten auf Substraten derart verändern, dass dieser kleiner wird. Durch einen kleineren Benetzungswinkel ergibt sich, dass auf die Oberfläche auftreffende Flüssigkeiten diese sehr gut benetzen und es zu keiner Tropfenbildung kommt. Stattdessen wird ein uniformes Benetzen herbeigeführt, welches die Transparenz des Substrates nicht beeinträchtigt. Besonders geeignete Materialien für ein solches strukturiertes Substrat sind solche Materialien, welche bereits hydrophile Eigenschaften aufweisen, z.B. Glasoberflächen.

In einer weiteren Ausgestaltung der Erfindung eignet sich das hierin offenbarte Verfahren und die hierin offenbarte Vorrichtung zum Erzeugen eines Substrates, welches hierarchische Strukturen, welche mittels Laserinterferenzstrukturierung durch eine Mehrfachbestrahlung desselben Interferenzpixels erzeugt wurden, aufweist, welche sich durch Anti-Fogging, also nicht-beschlagende Eigenschaften auszeichnen. Die Anti-Fogging Eigenschaften beruhen dabei darauf, dass Strukturen mit Abmessungen im Mikro- oder Submikrometerbereich, insbesondere hierarchische Strukturen mit Abmessungen im Mikro- und Submikrometerbereich den Benetzungswinkel von Flüssigkeiten auf Substraten derart verändern, dass dieser kleiner wird. Das strukturierte Substrat weist somit hydrophile oder superhydrophile Eigenschaften auf. Durch einen kleineren Benetzungswinkel ergibt sich, dass auf die Oberfläche auftreffende Flüssigkeiten diese sehr gut benetzen und es zu keiner Tropfenbildung kommt. Stattdessen wird ein uniformes Benetzen herbeigeführt, welches die Transparenz des Substrates nicht beeinträchtigt. Besonders geeignete Materialien für ein solches strukturiertes Substrat sind solche Materialien, welche bereits hydrophile Eigenschaften aufweisen, z.B. Glasoberflächen. Ein so strukturiertes Substrat kann vorteilhaft im Bereich der Automobil-, Luft- und Raumfahrttechnik, aber auch allgemein bei Verglasungen in der Gebäudetechnik zum Einsatz kommen.

In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, welche mittels Laserinterferenzstrukturierung erzeugt wurde, umfasst, welches eine erhöhte Oberflächenrauigkeit aufweist. Dabei basiert die erhöhte Oberflächenrauigkeit darauf, dass die Oberflächentextur durch die in das Substrat eingebrachte periodische Punktstruktur im Mikro- oder Submikrometerbereich verändert ist, insbesondere darauf, dass die Oberfläche des Substrats durch die eingebrachte periodische Punktstruktur Erhöhungen und Vertiefungen aufweist. Insbesondere kann eine erhöhte Oberflächenrauigkeit erzielt werden, indem ein Substrat mittels des hierin beschriebenen Verfahrens und der hierin beschriebenen Vorrichtung mit hierarchischen Strukturen mit Abmessungen im Mikro- und Submikrometer Bereich mittels Laserinterferenzstrukturierung durch eine Mehrfachbestrahlung desselben Interferenzpixels strukturiert wird. Ein so bearbeitetes Substrat ist vorteilhaft im Bereich der Fertigung einsetzbar, um bspw. die Haftreibung und/oder Gleitreibung zwischen technischen Komponenten zu erhöhen, oder in der Medizintechnik, um die Adhäsion von Zellen auf einer Fremdoberfläche zu erhöhen.

In einer Ausgestaltung der Erfindung eignet sich das hierin offenbarte Verfahren und die hierin offenbarte Vorrichtung zum Erzeugen eines Substrates, das eine periodische Punktstruktur im Mikro- oder Submikrometerbereich, welche mittels Laserinterferenzstrukturierung erzeugt wurde, umfasst, welches eine erhöhte Oberfläche im Vergleich zu einem unstrukturierten Substrat mit gleichen Außenabmessungen aufweist. Dabei trägt die periodische Punktstruktur im Mikro- oder Submikrometerbereich dazu bei, dass sich die Oberfläche des Substrats proportional zu der Dichte der Interferenzbereiche pro Interferenzpixel erhöht. Insbesondere kann eine erhöhte Oberfläche im Vergleich zu einem unstrukturierten Substrat mit gleichen Außenabmessungen erzielt werden, indem ein Substrat mittels des hierin beschriebenen Verfahrens und der hierin beschriebenen Vorrichtung mit hierarchischen Strukturen mit Abmessungen im Mikro- und Submikrometer Bereich mittels Laserinterferenzstrukturierung durch eine Mehrfachbestrahlung desselben Interferenzpixels strukturiert wird. Ein so bearbeitetes Substrat ist vorteilhaft in technischen Bereichen mit einem Anspruch an einen hohen Wärmetransport einsetzbar, da durch die erhöhte Oberfläche im Vergleich zu einem unstrukturierten Substrat mit gleichen Außenabmessungen eine größere Kapazität zum Wärmetausch bereitgestellt wird. Des Weiteren ist ein so bearbeitetes Substrat im Bereich der elektrischen Verbindungstechnik zum Reduzieren von Kontaktwiderständen einsetzbar, da durch die erhöhte Oberfläche im Vergleich zu einem unstrukturierten Substrat mit gleichen Außenabmessungen mehr Kontaktpunkte zwischen zu kontaktierenden Materialien herstellbar sind. Außerdem ist ein so strukturiertes Substrat im Bereich der Batterietechnik einsetzbar, insbesondere zum Strukturieren der Anode und Kathode, da durch die erhöhte Oberfläche im Vergleich zu einem unstrukturierten Substrat mit gleichen Außenabmessungen mehr Kapazität zum Austausch von Ladungsträgern zwischen dem Metall der Elektroden besteht.

Weiterhin eignet sich das hierin offenbarte Verfahren und die hierin offenbarte Vorrichtung zum Erzeugen eines Substrates umfassend eine periodische Punktstruktur mit Abmessungen im Mikro- oder Submikrometerbereich, welches antibakterielle (antiseptische) Eigenschaften aufweist. In einer bevorzugten Ausgestaltung weist die periodische Punktstruktur dabei Abmessungen auf, welche deutlich größer sind, zumindest 10% bis 30% größer sind, als die sich auf ihr ablagernden Bakterien. Dadurch werden die sich auf der Oberfläche ablagernden Bakterien isoliert und somit unschädlich gemacht. In einer besonders bevorzugten Ausgestaltung weist die periodische Punktstruktur dabei Abmessungen auf, welche deutlich kleiner sind, zumindest 10% bis 30% kleiner sind, als die sich auf ihr ablagernden Bakterien. Dadurch ist ein Anhaften der Bakterien auf der Oberfläche nicht möglich und die Oberfläche wird somit steril gehalten.

Ein durch das hierin offenbartes Verfahren und die hierin offenbarte Vorrichtung erzeugtes strukturiertes Substrat eignet sich darüber hinaus zum weiteren bearbeiten mittels eines weiteren Beschichtungsprozesses, wobei das Substrat eine physikalische und/oder chemische Beschichtung erhalten kann. Durch eine solche Beschichtung können die Eigenschaften des strukturierten Substrats, beispielsweise die Antireflexionseigenschaften und/oder hydrophile und/oder hydrophobe Eigenschaften verstärkt werden. Denkbar ist das Aufbringen einer chemischen Sprühbeschichtung und/oder das Aufbringen einer Beschichtung mittels chemical vapor deposition und/oder Sputtern und/oder Sol-Gel-Prozesse.

Nach einer bevorzugten Ausgestaltung der vorliegenden Erfindung umfasst das strukturierte Substrat eine Punktstruktur, die aus einem ersten und einem zweiten Interferenzpixel gebildet sind, wobei das erste und das zweite Interferenzpixel jeweils unabhängig voneinander eine periodische Punktstruktur mit Abmessungen im Mikro- und Submikrometer Bereich umfassen, wobei das erste Interferenzpixel und das zweite Interferenzpixel so zueinander überlagert angeordnet sind, dass der Versatz zwischen dem zweiten Interferenzpixel und dem ersten Interferenzpixel im Bereich von $10\% \leq x \leq 50\%$, insbesondere im Bereich von $20\% \leq x < 50\%$, besonders bevorzugt im Bereich von $25\% \leq x \leq 45\%$ der Interferenzperiode liegt. Besonders vorteilhaft kann hierdurch insbesondere mit den hierin definierten Abmessungen der Punktstrukturen (unabhängig von deren Anwendungsbereich) auf dem Substrat, insbesondere auf einem transparenten Substrat eine Strukturierung erzeugt werden, die Anti-Glare Eigenschaften aufweist.

Nach einer bevorzugten Ausgestaltung der Erfindung ist die periodische Punktstruktur derart ausgebildet, dass zumindest ein drittes Interferenzpixel so zu dem ersten und dem zweiten Interferenzpixel überlagert angeordnet ist, dass der Versatz zwischen dem dritten Interferenzpixel und dem zweiten Interferenzpixel im Bereich von $10\% \leq x \leq 50\%$, insbesondere im Bereich von $20\% \leq x < 50\%$, besonders bevorzugt im Bereich von $25\% \leq x \leq 45\%$ der Interferenzperiode liegt.

**Verwendung des strukturierten Substrates**

Das hierin definierte strukturierte Substrat mit Antireflexionseigenschaften findet beispielsweise Anwendung bei Photovoltaikanlagen, wobei durch die Einbringung antireflektierender Eigenschaften die Effizienz dieser Photovoltaikanlagen wesentlich erhöht werden kann. Eine große Herausforderung im Bereich der Photovoltaikanlagen liegt bei den großen Verlusten aufgrund der Reflexion der Sonnenstrahlen. Im Schnitt verursachen Reflexionen 40 % Energie-/Leistungsverluste pro Anlage. Der Wirkungsgrad von Photovoltaikanlagen muss entsprechend stetig verbessert werden. Einer der vielversprechendsten Ansätze ist die Reduktion von Reflexion mit Hilfe von Antireflexbeschichtungen und/oder Texturierungen der Oberfläche. Der Einsatz des hierin offenbarten Verfahrens vereinfacht, beschleunigt und verbessert die Behandlung der Oberflächen.

Es ist darüber hinaus bekannt, dass Monitore und Bildschirme oft an festen Orten platziert sind und somit anfällig für ungünstige Lichteinfälle sind, die zu Sichtproblemen des Betrachters führen. Zwar existieren grundsätzlich Möglichkeiten, diesen Effekt zu minimieren, allerdings finden diese Ansätze keine breite Anwendung, da sie eher die Symptome lindern, als das Problem konkret zu lösen. Das hierin definierte strukturierte Substrat mit Antireflexionseigenschaften eignet sich beispielsweise ideal zur Aufbringung bzw. Einbindung im Darstellungsbereich bspw. in Form als Antireflexionsverglasung von Monitoren, Bildschirmen und Displays.

Ein weiteres Anwendungsgebiet eröffnet sich im Bereich der Entspiegelung innerhalb von Glasfasern, was für höhere Übertragungsraten sorgt und die Rückreflexionen minimiert. Das hierin offenbarte Verfahren eignet sich daher ideal zur Strukturierung von Glasfasern, so dass die derart strukturierte Glasfaser ein weiteres Anwendungsbeispiel für ein hierin definiertes strukturierte Substrat mit Antireflexionseigenschaften bietet. Von der vorliegenden Erfindung ist daher auch die Verwendung eines hierin definierten strukturierten Substrats als Komponente von Glasfasern mit umfasst.

Darüber hinaus haben die Erfinder herausgefunden, dass sich das hierin definierte Verfahren zur Strukturierung von Fensterscheiben (als ein weiteres Beispiel für eine Antireflexionsverglasung) eignet. So können die hierin offenbarten strukturierten Substrate beispielsweise in Form einer Antireflexionsverglasung oder als Folierung auf Häuserfassaden, bevorzugt flächigen und/oder transparenten Substraten, als wärmeisolierende Verglasungen verwendet werden, die beispielsweise zum Schutz vor gebündelter Sonneneinstrahlung durch gekrümmte Häuserfassaden und zur besseren Wärmedämmung von Gebäuden verwendet werden können.

Darüber hinaus kann eine Reduktion der Reflexion bei Mikroskopen und Teleskopen den Kontrast der damit aufgezeichneten Bilder erhöhen, wodurch die Effizienz und der Einsatz dieser optischen Geräte erhöht werden. Von der vorliegenden Erfindung ist daher auch die Verwendung eines hierin definierten strukturierten Substrats als optisches Element mit periodischen Punktstruktur im Mikro- oder Submikrometerbereich in optischen Geräten, wie bspw. Mikroskopen und Teleskopen mit umfasst, für die die Strahlführung, Strahlformung, Strahlbündelung und/oder Strahlfokussierung wesentlich sind.

Es ist ebenfalls zweckdienlich, dass hierin definierte strukturierte Substrat als Negativform (sog. Master) bspw. innerhalb eines Prägeprozesses zur indirekten Aufbringung oder Erzeugung von Strukturen auf einem anderen Substrat zu verwenden. Beispielsweise ist dies bei Rolle-zu-Rolle-Prozessen relevant, bei denen mit Hilfe eines Heiß- oder UV-Prägeprozesses Strukturen von einem sog. Master (meist Metall wie z.B. Nickel) auf eine Polymerfolie (z.B. PET) im Endlosverfahren übertragen werden. Somit können auf anderen Substraten die inversen Strukturen im Hochdurchsatz als periodische Punktstrukturen im Mikro- oder Submikrometerbereich erzeugt werden.

Die erfindungsgemäße Vorrichtung und das erfindungsgemäße Verfahren bieten außerdem die Möglichkeit, ohne großen technischen Auswand ein Substrat flächig mit hydrophoben oder superhydrophoben zu erzeugen. Ein derart strukturiertes Substrat hat ein breites Anwendungsspektrum in Bereichen, in denen die selbstreinigenden Eigenschaften von hydrophoben und oder superhydrophoben Substraten erwünscht sind, bspw. im Bereich von Automobilkomponenten, Displays oder Verglasung, aber auch im Bereich der Luftfahrt oder Antennentechnik.

Die erfindungsgemäße Vorrichtung und das erfindungsgemäße Verfahren bieten außerdem die Möglichkeit, ohne großen technischen Aufwand ein Substrat flächig mit hydrophilen oder superhydrophilen zu erzeugen. Ein derart strukturiertes Substrat hat ein breites Anwendungsspektrum in Bereichen, in denen die homogenen Benetzungseigenschaften von hydrophilen und oder superhydrophilen Substraten erwünscht sind, bspw. im Bereich von Automobilkomponenten, Displays oder Verglasung, aber auch im Bereich der Luftfahrt oder Antennentechnik.

Weiterhin bietet das erfindungsgemäße Verfahren und die erfindungsgemäße Vorrichtung auch die Möglichkeit zum Erzeugen eines strukturierten Substrates, welches sich zur weiteren Bearbeitung, beispielsweise einer chemischen und/oder physikalischen Behandlung, insbesondere zum Beschichten mittels einer chemischen Sprühbeschichtung und/oder eignet, um die resultierenden Antireflexionseigenschaften und/oder hydrophoben oder superhydrophoben und/oder hydrophilen oder superhydrophilen Eigenschaften des Substrats zu steigern und/oder zu modifizieren.

Nach einer bevorzugten Ausgestaltung der vorliegenden Erfindung eignet sich das hierin offenbarte Verfahren dazu, eine Substratoberfläche derart zu strukturieren, dass diese Anti-Glare Eigenschaften aufweist. Hierzu eignen sich insbesondere solche strukturierten Substrate mit einer Punktstruktur, die - wie hierin definiert - aus einem ersten und einem zweiten Interferenzpixel gebildet sind, wobei das erste und das zweite Interferenzpixel jeweils unabhängig voneinander eine periodische Punktstruktur mit Abmessungen im Mikro- und Submikrometer Bereich umfassen, wobei das erste Interferenzpixel und das zweite Interferenzpixel so zueinander überlagert angeordnet sind, dass der Versatz zwischen dem zweiten Interferenzpixel und dem ersten Interferenzpixel im Bereich von 10% ≤ x ≤ 50%, insbesondere im Bereich von 20% ≤ x < 50%, besonders bevorzugt im Bereich von 25% ≤ x ≤ 45% der Interferenzperiode liegt.

## Bezugszeichenliste

1 Laserstrahlungsquelle
2 Strahlteilerelement
3 Strahlengang
4 Fokussierelement
5 Substrat
6 weiteres Umlenkelement
7 Umlenkelement
8 Polarisationselement
9 Fokussierspiegel bzw. Galvo-Spiegel
31 optische Achse

91 Polygonrad

## Ausführungsbeispiele

Anhand folgender Figuren und Ausführungsbeispiele wird die vorliegende Erfindung näher erläutert, ohne die Erfindung auf diese zu beschränken. Insbesondere sind in den einzelnen Figuren gezeigte und zu dem jeweiligen Beispiel beschriebene Merkmale nicht auf das jeweilige Einzelbeispiel beschränkt.

Dabei zeigt

**Fig. 1:** eine schematische perspektivische Ansicht einer erfindungsgemäßen Vorrichtung.

**Fig. 2:** eine schematische perspektivische Ansicht einer erfindungsgemäßen Vorrichtung, die ein Umlenkelement (6) zur Parallelisierung der Teilstrahlen enthält.

**Fig. 3:** eine schematische perspektivische Ansicht einer erfindungsgemäßen Vorrichtung, die ein Umlenkelement (7) zur Aufweitung des Winkels der Teilstrahlen zur optischen Achse des Strahlengangs (3) enthält.

**Fig. 4A:** eine schematische perspektivische Ansicht einer erfindungsgemäßen Vorrichtung, die optische Elemente (6) mit einer planaren, reflektierenden Oberfläche, die die Teilstrahlen auf das Fokussierelement (4) umlenken, enthält.

**Fig. 4B:** eine schematische perspektivische Ansicht einer erfindungsgemäßen Vorrichtung, die als optisches Element zur Strahlformung einen Galvo-Spiegel (9) umfasst, was eine ortsfeste Positionierung des zu strukturierenden Substrats während des Prozesses der Strukturierung erlaubt.

**Fig. 5:** eine schematische perspektivische Ansicht einer erfindungsgemäßen Vorrichtung, wobei die Vorrichtung ein Polarisationselement (8), welches den Phasenverlauf der Teilstrahlen zueinander verschiebt, enthält, wobei a) das Strahlteilerelement (2) im Strahlengang (3) nah an der Laserstrahlungsquelle (1) positioniert ist. b) das Strahlteilerelement (2) im Strahlengang (3) nah am Umlenkelement (7) positioniert ist.

**Fig. 6:** eine schematische Ansicht der sich auf der Oberfläche oder im Inneren des Substrats ergebenden Interferenzpixel mit der Weite D, und die Verteilung der einzelnen Interferenzpixel auf der Oberfläche oder im Inneren des Substrats, wobei die Interferenzpixel zueinander verschoben sind mit der Pixeldichte Pd.

**Fig. 7:** eine schematische perspektivische Ansicht des strukturierten Substrats (5) mit den erzeugten periodischen Punktstrukturen, bestehend aus inversen Zapfen, mit Abmessungen im Mikro- und Submikrometerbereich, und symbolisch die Transmission von einfallenden elektromagnetischen Wellen mit Wellenlängen größer als die Strukturperiode der erzeugten Strukturen, sowie die Beugung von einfallenden elektromagnetischen Wellen mit Wellenlängen im Bereich oder kleiner der erzeugten Strukturen.

**Fig. 8:** eine schematische perspektivische Ansicht einer erfindungsgemäßen Vorrichtung, die als optisches Element einen Galvospiegel (9) mit einer planaren, reflektierenden Oberfläche, die die Teilstrahlen auf das Fokussierelement (4) umlenken, sowie ein Polygonrad (91) enthält.

**Fig. 9:** Eine grafische Darstellung des Diffraktionswinkels von einfallendem Licht über der Wellenlänge des einfallenden Lichts für strukturierte Substrate mit drei unterschiedlichen Strukturweiten.

**Fig. 10:** eine schematische perspektivische Ansicht des strukturierten Substrats (5) mit den erzeugten periodischen Punktstrukturen, bestehend aus inversen Zapfen, mit Abmessungen im Mikrometerbereich, der eine periodische Wellenstruktur im Submikrometerbereich überlagert ist.

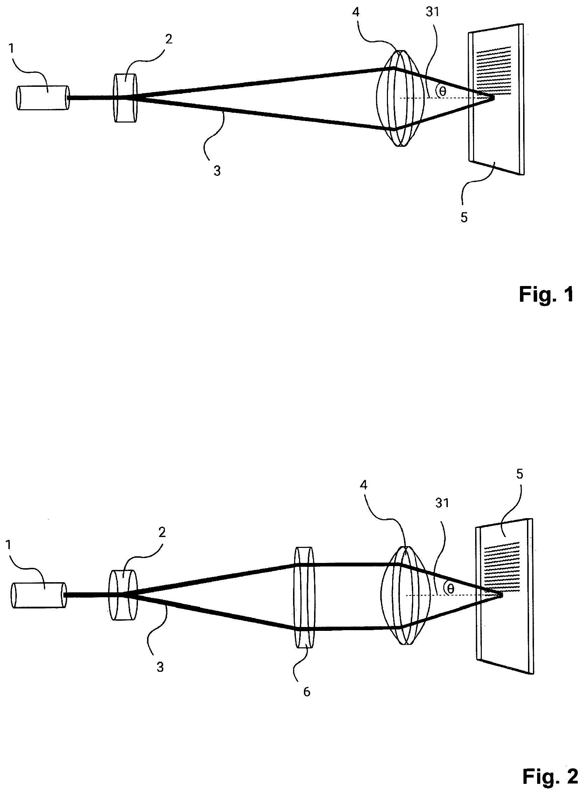

**Fig. 1** visualisiert in einem ersten Ausführungsbeispiel die erfindungsgemäße Vorrichtung, umfassend eine Laserstrahlungsquelle (1) zum Emittieren eines Laserstrahls. Im Strahlengang (3) des Laserstrahls hinter der Laserstrahlungsquelle (1) angeordnet, befindet sich ein Strahlteilerelement (2), welches im Strahlengang (3) beweglich angeordnet ist. Im Strahlengang (3) des Laserstrahls hinter dem Strahlteilerelement (2) angeordnet, befindet sich ein Fokussierelement (4). Im Strahlengang (3) des Laserstrahls hinter dem Fokussierelement (4) angeordnet, befindet sich eine Haltevorrichtung, auf der ein Substrat (5), bevorzugt flächiges und/oder transparentes Substrat, gelagert ist.

In dieser Ausgestaltung emittiert die Laserstrahlungsquelle (1) einen gepulsten Laserstrahl. Es handelt sich hier bei der Laserstrahlungsquelle um einen UV Laser mit einer Wellenlänge von 355 nm Wellenlänge und einer Pulsdauer von 12 ps. Das Strahlungsprofil der Laserstrahlungsquelle entspricht in dieser Ausführungsform einem Top-Hat-Profil.

In diesem Ausführungsbeispiel entspricht das Strahlteilerelement (2) einem diffraktiven Strahlteilerelement. Ein diffraktives Strahlteilerelement ist hier ein Strahlteilerelement, welches Mikro- oder Nanostrukturen enthält. Das Strahlteilerelement (2) unterteilt den Laserstrahl in 4 Teilstrahlen.

Das Fokussierelement (4) entspricht in diesem Ausführungsbeispiel einer refraktiven, sphärischen Linse, die die im Wesentlichen parallel zueinander verlaufenden Teilstrahlen so auf das Substrat (5), bevorzugt flächige und/oder transparente Substrat, lenkt, dass sie dort in einem Interferenzbereich interferieren. Der Interferenzwinkel entspricht in dieser Ausgestaltung 27,2°, woraus eine Strukturperiode von 550 nm für die periodische Punktstruktur bei dem gleichen Polarisationszustand resultiert.

Gemäß diesem Ausführungsbeispiel wird das flächige Substrat einmal bestrahlt, sodass sich eine Bearbeitungsdauer pro Struktureinheit, d. h. pro Interferenzpixel, von 12 ps ergibt.

Bei dem Substrat (5), bevorzugt flächigen und/oder transparenten Substrat, handelt es sich um ein Glas, ganz speziell ein Quarzglas, welches auf einer Haltevorrichtung gelagert ist, sodass es in der xy-Ebene, senkrecht zum Strahlengang des von der Laserstrahlungsquelle (1) emittierten Laserstrahls beweglich ist.

**Fig. 2** visualisiert in einem weiteren Ausführungsbeispiel die Vorrichtung wie in Fig. 1 beschrieben, zusätzlich umfassend ein Umlenkelement (6), welches sich im Strahlengang (3) des Lasers nach dem Strahlteilerelement (2) und dem Fokussierelement (4) befindet.

In dieser Ausgestaltung ist das Umlenkelement eine konventionelle, refraktive, konvexe Linse. Die Teilstrahlen treffen derart auf das Umlenkelement (6) auf, dass sie nach Durchlaufen des Umlenkelements im Wesentlichen parallel zueinander verlaufen. Dadurch lässt sich der Punkt, in dem die Teilstrahlen auf der Oberfläche oder im Inneren des Substrats interferieren, einstellen.

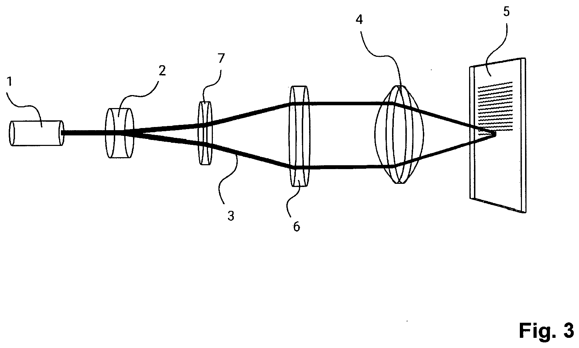

**Fig. 3** visualisiert in einem weiteren Ausführungsbeispiel eine Vorrichtung basierend auf dem in Fig. 1 und Fig. 2 gezeigten Aufbau. Zusätzlich umfasst dieser Aufbau ein weiteres Umlenkelement (7), welches im Strahlengang (3) des Lasers zwischen dem Strahlteilerelement (2) und dem Umlenkelement (6) angeordnet ist.

In dieser Ausgestaltung ist das weitere Umlenkelement (7) eine konventionelle, refraktive, konkave Linse. Die Teilstrahlen treffen derart auf das weitere Umlenkelement auf, sodass ihr Winkel zur optischen Achse des Strahlengangs aufgeweitet wird. Dadurch lässt sich der Interferenzwinkel, mit dem die Teilstrahlen auf der Oberfläche oder im Inneren des Substrats, bevorzugt flächigen und/oder transparenten Substrats, interferieren, verändern.

In dieser Ausgestaltung sind alle optischen Elemente abgesehen vom Strahlteilerelement (2) entlang der optischen Achse des Strahlengangs (3) fixiert. Der Interferenzwinkel der Teilstrahlen auf dem Substrat wird über eine Verschiebung des Strahlteilerelements (2) entlang der optischen Achse des Strahlengangs eingestellt.

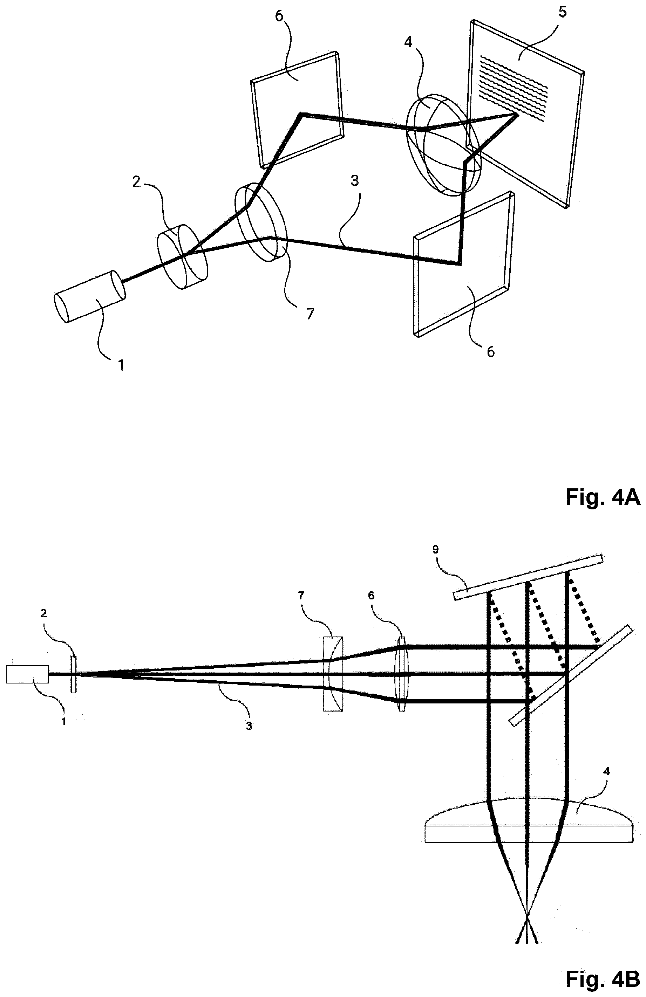

**Fig. 4A** zeigt in einem weiteren Ausführungsbeispiel eine Vorrichtung wie in Fig. 3, umfassend die optischen Elemente (6) mit einer planaren, reflektierenden Oberfläche, die derart eingerichtet sind, dass sie die Teilstrahlen auf das Fokussierelement (4) umlenken.

In dieser Ausgestaltung werden die zumindest drei Teilstrahlen durch Verschiebung der optischen Elemente (6) in einem bevorzugten Winkel auf das Substrat gelenkt. Dadurch kann auf ein Umlenkelement in Form einer Linse (Bezugszeichen (6) in Fig. 3) verzichtet werden.

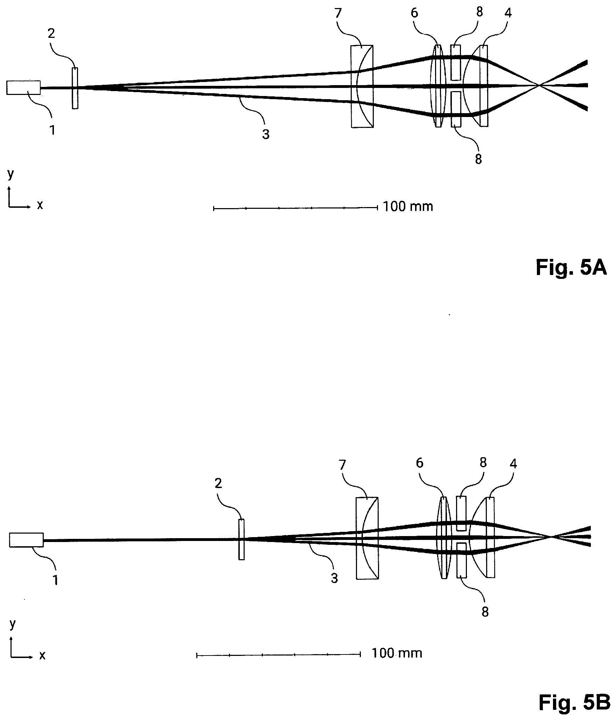

**Fig. 5** visualisiert in einem weiteren Ausführungsbeispiel eine Vorrichtung wie in Fig. 3, zusätzlich umfassend je ein Polarisationselement (8) pro Teilstrahl, welche im Strahlengang (3) des Laserstrahls zwischen dem Umlenkelement (6) und dem Fokussierelement (4) angeordnet sind.

Das Polarisationselement ist derart angeordnet, dass es die Polarisierung der einzelnen Teilstrahlen zueinander so verändert, dass sich eine Veränderung des Interferenzmusters ergibt.

Diese Ausgestaltung ist in zwei unterschiedlichen Konfigurationen dargestellt. In Fig. 5 a) ist das Strahlteilerelement (2) im Strahlengang (3) nah an der Laserstrahlungsquelle (1) positioniert. In Fig. 5 b) ist das Strahlteilerelement (2) im Strahlengang (3) nah am Umlenkelement (7) positioniert. Auf diese Weise lässt sich das Interferenzmuster der interferierenden Teilstrahlen auf der Oberfläche des Substrats (5) stufenlos einstellen, ohne dass die anderen optischen Elemente im Aufbau oder das Substrat bewegt werden müssen.

Zusätzlich wäre es auch denkbar, dass die Anordnung ein zusätzliches optisches Element zur Strahlformung enthält, das im Strahlengang (3) des Laserstrahls der Laserstrahlungsquelle (1) nachgeordnet ist. In dieser Ausgestaltung entspricht das Strahlungsprofil der Laserstrahlungsquelle einem Gauß-Profil. Das optische Element zur Strahlformung wandelt dieses Profil in ein Top-Hat-Profil um.

**Fig. 6** enthält eine schematische Ansicht der sich auf der Oberfläche oder im Inneren des Substrats ergebenden Interferenzpixel mit der Weite D, und die Verteilung der einzelnen Interferenzpixel auf der Oberfläche oder im Inneren des Substrats, wobei die Interferenzpixel zueinander verschoben sind mit der Pixeldichte Pd.

In dieser Ausgestaltung ist die Pixeldichte Pd kleiner als die Weite eines Interferenzpixels, D. Dadurch kann durch Bewegen des Substrats (5) mittels eines gepulsten Laserstrahls eine flächige homogene periodische Punktstruktur auf der Oberfläche oder im Inneren eines Substrats, bevorzugt flächigen und/oder transparenten Substrats, erzeugt werden.

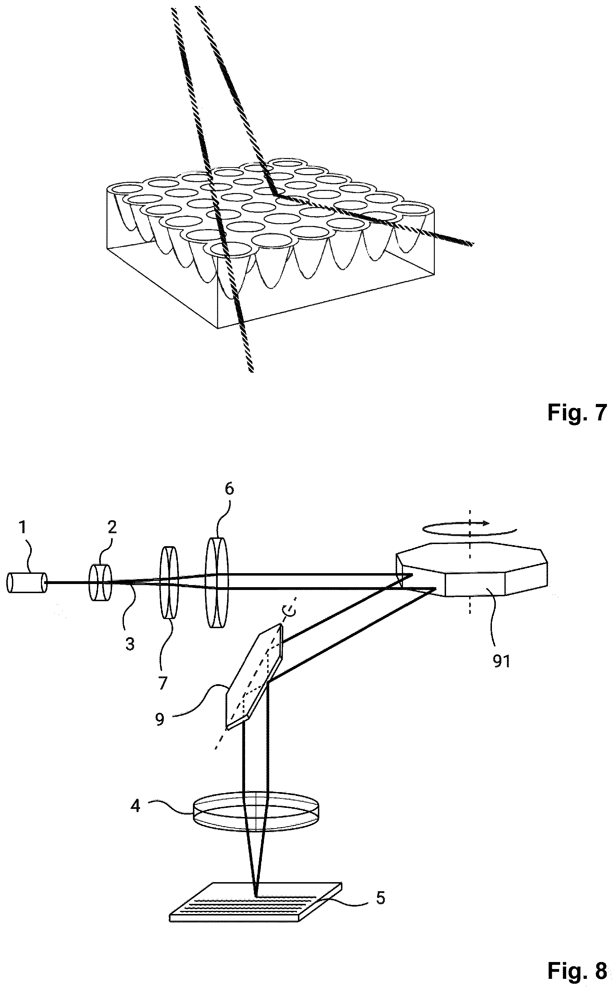

**Fig. 7** visualisiert das durch das erfindungsgemäße Verfahren erzeugte strukturierte Substrat (5) mit den erzeugten periodischen Punktstrukturen, bestehend aus inversen Zapfen, mit Abmessungen im Mikro- und Submikrometerbereich. Es wird zudem symbolisch die Transmission von einfallenden elektromagnetischen Wellen mit Wellenlängen größer als die Strukturperiode der erzeugten Strukturen, sowie die Beugung von einfallenden elektromagnetischen Wellen mit Wellenlängen im Bereich oder kleiner der erzeugten Strukturen verdeutlicht.

**Fig. 8** zeigt in einem weiteren Ausführungsbeispiel eine Vorrichtung wie in Fig. 4B, umfassend das optische Element (91) mit einer planaren, reflektierenden Oberfläche, wobei es sich um ein Polygonrad handelt, welches derart eingerichtet ist, dass es um eine eingezeichnete Achse rotiert. Dabei werden die einfallenden Teilstrahlen derart abgelenkt, dass sie auf einen Galvospiegel (9) treffen, welcher die Strahlen über ein Fokussierelement (4) auf das Substrat lenkt. Die Rotation des Polygonrads bewirkt dabei, dass der Punkt, in dem die Strahlen auf dem Substrat gebündelt werden während des Belichtungsprozesses entlang einer Linie beweglich ist. Die Teilstrahlen scannen also das Substrat, was zu einer erhöhten Prozessgeschwindigkeit führt.

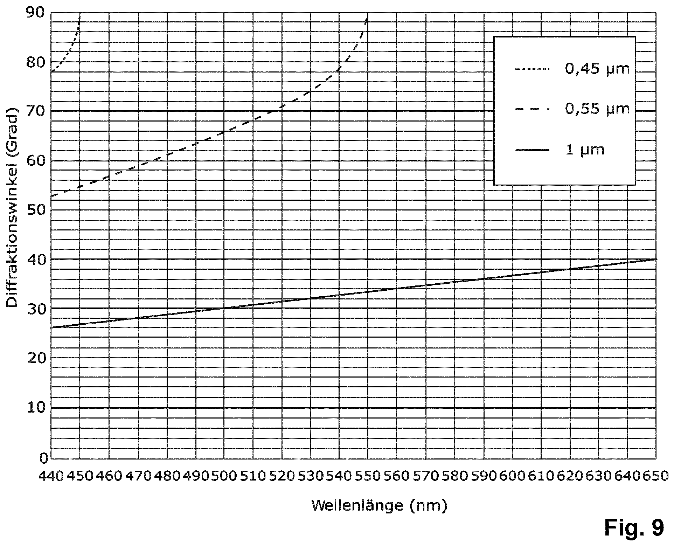

**Fig. 9** zeigt in einer grafischen Darstellung die Transmissions- bzw. Beugungsfähigkeit von einem strukturierten Substrat abhängig von der Strukturweite auf. Dabei wird der Diffraktionswinkel von Licht in Abhängigkeit von dessen Wellenlänge für Strukturen mit drei unterschiedlichen Strukturweiten gezeigt. Ist die Wellenlänge des einfallenden Lichts größer als die Strukturweite, so wird das Licht vollständig transmittiert. Bei Wellenlängen im Bereich der Strukturweite oder kleiner kommt es zur Diffraktion. Die Diffraktionswinkel können aus der Grafik entnommen werden.

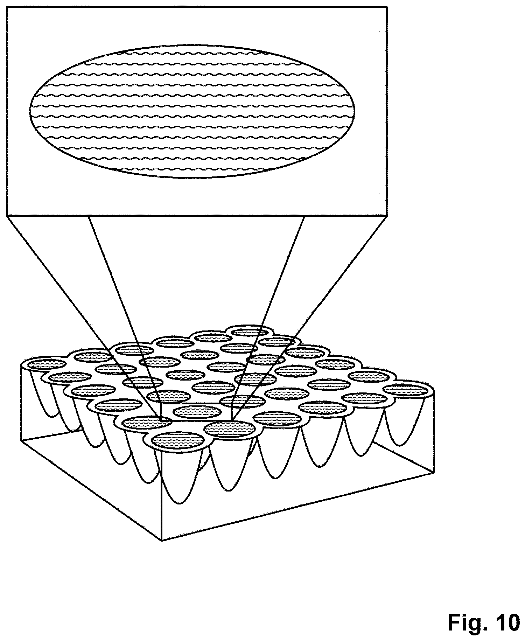

**Fig. 10** visualisiert das durch das erfindungsgemäße Verfahren erzeugte strukturierte Substrat (5) mit den erzeugten periodischen Punktstrukturen, bestehend aus inversen Zapfen, mit Abmessungen im Mikrometerbereich. Dieser periodischen Punktstruktur im Mikrometerbereich überlagert ist eine periodische Wellenstruktur im Submikrometerbereich, welche ebenfalls durch das hierin beschriebene erfindungsgemäße Verfahren in einem Produktionsschritt erzeugbar ist.

**Patentansprüche**

1. **Strukturiertes** Substrat (5) mit Antireflexionseigenschaften, umfassend eine **periodische Punktstruktur** im Mikro- oder Submikrometerbereich,

    wobei die periodische Punktstruktur aus inversen **Zapfen** gebildet ist,
    wobei die Zapfen periodisch mit einem Abstand im Bereich von 50 nm bis 50 $\mu$m angeordnet sind,
    wobei der periodischen Punktstruktur eine weitere Struktur überlagert ist,
    wobei die überlagernde Struktur eine quasi-periodische Wellenstruktur aufweist, wobei das Material auf der Oberfläche des Substrats im Bereich der sich überlagernden Struktur eine Abfolge von Wellenbergen und Wellentälern aufweist, deren Periodizität im Bereich von 100 nm bis 1000 nm liegt.

2. Strukturiertes Substrat nach Anspruch 1, wobei die periodische Punktstruktur derart ausgebildet ist, dass das strukturierte Substrat elektromagnetische Strahlung mit einer Wellenlänge von mehr als 550 nm, bevorzugt von mehr als 500 nm, ganz besonders bevorzugt von mehr als 450 nm transmittiert.

3. Strukturiertes Substrat nach Anspruch 1 oder 2, umfassend eine periodische Punktstruktur im Mikro- oder Submikrometerbereich, wobei der periodischen Punktstruktur eine periodische Wellenstruktur überlagert ist, wobei die Wellenberge mit einem Abstand im Bereich von 20 nm bis 5 µm angeordnet sind.

4. Strukturiertes Substrat nach einem der Ansprüche 1 bis 3, wobei das strukturierte Substrat eine Punktstruktur umfasst, die aus einem ersten und einem zweiten Interferenzpixel gebildet ist, wobei das erste und das zweite Interferenzpixel jeweils unabhängig voneinander eine periodische Punktstruktur mit Abmessungen im Mikro- und/oder Submikrometerbereich umfassen, wobei das erste Interferenzpixel und das zweite Interferenzpixel so zueinander überlagert angeordnet sind, dass der Versatz zwischen dem zweiten Interferenzpixel und dem ersten Interferenzpixel im Bereich von 10% ≤ x ≤ 50% der Interferenzperiode liegt.

5. Strukturiertes Substrat nach einem der Ansprüche 1 bis 4, wobei strukturierte Substrat ein transparentes Material umfasst, und wobei das transparente Material aus der Gruppe umfassend Glas, feste Polymere, transparente Keramiken oder Mischungen daraus ausgewählt ist.

6. Strukturiertes Substrat nach einem der Ansprüche 1 bis 5, wobei der Brechungsindex des strukturierten Substrats graduell ist.

7. Laserinterferenzstrukturierungsvorrichtung zur direkten Laserinterferenzstrukturierung eines Substrats zur Erzeugung eines strukturierten Substrats nach einem der Ansprüche 1-6, aufweisend

- eine Laserstrahlungsquelle (1) zum Emittieren eines Laserstrahls,
- ein Strahlteilerelement (2), das im Strahlengang (3) des Laserstrahls angeordnet ist,
- ein Fokussierelement (4), das im Strahlengang (3) des Lasers dem Strahlteilerelement (2) nachgeordnet ist und das derart eingerichtet ist, dass es die Teilstrahlen derart durchlaufen, dass die Teilstrahlen auf der Oberfläche oder im Volumen eines Substrats (5) in einem Interferenzbereich interferierbar sind,

**dadurch gekennzeichnet, dass**

der Strahlteiler (2) entlang seiner optischen Achse im Strahlengang (3) frei beweglich ist, der Strahlteiler (2) dazu eingerichtet ist, den einfallenden Laserstrahl, der von der Laserstrahlungsquelle (1) ausgesandt wird, in zumindest drei Teilstrahlen aufzuteilen, wobei im Strahlengang (3) der Laserstrahlungsquelle (1) dem Strahlteilerelement (2) nachgeordnet ein erstes Umlenkelement (7) angeordnet ist, das derart eingerichtet ist, dass die zumindest drei Teilstrahlen beim Durchlaufen des Umlenkelements (7) aufgeweitet werden.

8. Vorrichtung nach Anspruch 7, wobei im Strahlengang (3) der Laserstrahlungsquelle (1) und dem Strahlteilerelement (2) nachgeordnet ein weiteres Umlenkelement (6) angeordnet ist, das derart eingerichtet ist, dass es die Teilstrahlen derart umlenkt, dass sie nach Austritt aus dem weiteren Umlenkelement (6) im Wesentlichen parallel zueinander verlaufen.

9. Vorrichtung nach einem der Ansprüche 7 oder 8, wobei das erste Umlenkelement (7) eine konkave Linse ist.

10. Vorrichtung nach einem der Ansprüche 8 oder 9, wobei das weitere Umlenkelement (6) eine konvexe Linse ist.

11. Vorrichtung nach einem der Ansprüche 7 bis 10, wobei es sich bei dem Laserstrahlungsquelle um eine gepulste Laserstrahlungsquelle mit Pulsweiten im Bereich von 10 Nanosekunden bis 10 Femtosekunde, handelt.

12. **Verfahren** zur Herstellung eines Substrats mit einer periodischen Punktstruktur im Mikro- oder Submikrometerbereich mittels Laserinterferenzstrukturierung, insbesondere zur Erzeugung eines strukturierten Substrats nach einem der Ansprüche 1-6, umfassend die folgenden Schritte:

a) Bereitstellen eines Substrates (5), vorzugsweise umfassend ein transparentes Material,
b) Emittieren eines Laserstrahls aus einer Laserstrahlungsquelle (1),
c) Teilen des Laserstrahls durch ein Strahlteilerelement (2) in zumindest drei Teilstrahlen,
d) Fokussieren der Teilstrahlen auf die Oberfläche oder innerhalb des Volumens des Substrats (5), sodass die Teilstrahlen auf der Oberfläche oder innerhalb des Volumens des Substrats konstruktiv und destruktiv interferieren, **dadurch gekennzeichnet, dass** die zumindest drei Teilstrahlen durch das Fokussieren so auf dem Substrat überlagert werden, dass eine periodische Punktstruktur im Mikro- oder Submikrometerbereich auf der Oberfläche oder im Volumen des Substrats erzeugt wird, wobei die periodische Punktstruktur aus inversen **Zapfen** gebildet ist, wobei die inversen Zapfen periodisch mit einem Abstand im Bereich von 50 nm bis 50 μm zueinander angeordnet sind, wobei der periodischen Punktstruktur eine weitere Struktur überlagert ist, wobei die überlagernde Struktur eine quasi-periodische Wellenstruktur aufweist, wobei das Material auf der Oberfläche des Substrats im Bereich der sich überlagernden Struktur eine Abfolge von Wellenbergen und Wellentälern aufweist, deren Periodizität im Bereich von 100 nm bis 1000 nm liegt.

13. Verfahren nach Anspruch 12, wobei die Strukturperiode der erzeugten periodischen Punktstruktur des Substrates (5) im Mikro- oder Submikrometerbereich durch Bewegen des Strahlteilerelements (2) entlang seiner optischen Achse im Strahlengang (3) stufenlos einstellbar ist.

14. Verfahren nach Anspruch 12 oder 13, wobei das Substrat (5) ein transparentes Material umfasst und die Teilstrahlen im Innern des transparenten Materials interferieren.

15. Verfahren nach einem der Ansprüche 12 - 14 umfassend die folgenden Schritte:

a) Applizieren eines ersten Pulses auf der Oberfläche eines Substrates (5), der ein erstes Interferenzpixel auf der Oberfläche des Substrates (5) oder in dem Substrat (5) generiert,
b) Applizieren eines zweiten Pulses auf der Oberfläche eines Substrates (5), der ein zweites Interferenzpixel auf Oberfläche des Substrates (5) oder in dem Substrat (5) generiert, wobei das erste und das zweite Interferenzpixel jeweils unabhängig voneinander eine periodische Punktstruktur mit Abmessungen im Mikro- und Submikrometer Bereich umfassen, **dadurch gekennzeichnet, dass** der Versatz zwischen dem zweiten Interferenzpixel und dem ersten Interferenzpixel im Bereich von 10% ≤ x ≤ 50% der Interferenzperiode liegt.

16. Verfahren nach Anspruch 15, wobei nach Schritt b) ein dritter Puls auf der Oberfläche eines Substrates (5) appliziert wird, wobei das dritte Interferenzpixel eine periodische Punktstruktur mit Abmessungen im Mikro- und Submikrometer Bereich umfassen, wobei der dritte Puls ein drittes Interferenzpixel auf der Oberfläche des Substrates (5) oder in dem Substrat (5) generiert, wobei der dritte Interferenzpixel im Bezug zum zweiten Interferenzpixel einen Versatz im Bereich von 10% ≤ x ≤ 50% der Interferenzperiode aufweist,

17. Verfahren nach Anspruch 15, wobei der Versatz der Interferenzperiode in zumindest einer Raumrichtung gleichmäßig ausgebildet ist.

18. Verwendung des strukturierten Substrats nach einem der Ansprüche 1 bis 6 in Photovoltaikanlagen.

19. Verwendung des strukturierten Substrats nach einem der Ansprüche 1 bis 6 als Antireflexionsverglasung von Monitoren, Bildschirmen und Displays.

20. Verwendung des strukturierten Substrats nach einem der Ansprüche 1 bis 6 in Glasfasern.

21. Verwendung des strukturierten Substrats nach einem der Ansprüche 1 bis 6 als Negativform zur indirekten Aufbringung oder Erzeugung von Strukturen auf einem anderen Substrat.

**Claims**

1. Patterned substrate (5) with anti-reflective properties comprising a periodic dot structure in the micro- or sub-micrometer range,

wherein the periodic dot structure is formed of inverse cones,
wherein the cones are arranged periodically with a distance from one another in the range of 50 nm to 50 μm
wherein a further structure is superimposed on the periodic dot structure,
wherein the superimposed structure has a quasi-periodic wave structure,
wherein the material on the surface of the substrate in the region of the superimposed structure has a sequence of wave crests and wave troughs, the periodicity of which is in the range of 100 nm to 1000 nm.

2. Patterned substrate according to claim 1, wherein the periodic dot structure is formed such that the structured substrate transmits electromagnetic radiation with a wavelength of more than 550 nm, preferably of more than 500 nm, particularly preferably of more than 450 nm.

3. Patterned substrate according to claim 1 or 2, comprising a periodic dot structure in the micro- or submicrometer range, wherein a periodic wave structure is superimposed on the periodic dot structure, wherein the wave crests are arranged with a spacing in the range from 20 nm to 5 $\mu$m.

4. Patterned substrate according to one of the claims 1 to 3, wherein the patterned substrate comprises a dot structure formed of a first and a second interference pixel, wherein the first and the second interference pixel each independently comprise a periodic dot structure having dimensions in the micro- and/or sub-micrometer range, wherein the first interference pixel and the second interference pixel are arranged superimposed to each other such that the offset between the second interference pixel and the first interference pixel is in the range of $10\% \leq x \leq 50\%$ of the interference period.

5. Patterned substrate according to any one of the claims 1 to 4, wherein the patterned substrate comprises a transparent material, and wherein the transparent material is selected from the group comprising glass, solid polymers, transparent ceramics or mixtures thereof.

6. Patterned substrate according to any one of the claims 1 to 5, wherein the refractive index of the patterned substrate is gradual.

7. Laser interference patterning apparatus for direct laser interference patterning of a substrate for producing a patterned substrate according to any one of the claims 1 to 6, comprising

   - a laser radiation source (1) for emitting a laser beam,
   - a beam splitter element (2) arranged in the optical path (3) of the laser beam,
   - a focusing element (4) which is arranged in succession of the beam splitter element in the optical path of the laser and configured so that the sub-beams pass through it in such a way that the sub-beams are interfereable on the surface or in the volume of a substrate (5) in an interference region,

   **characterized in that**

   the beam splitter (2) is freely movable along its optical axis in the optical path (3),
   the beam splitter (2) is set up to split the incident laser beam emitted by the laser radiation source (1) into at least three sub-beams,
   wherein a first deflecting element (7) is arranged in succession of the beam splitter element (2) in the optical path (3) of the laser radiation source (1), which is configured so that the at least three sub-beams are widened when passing through the deflecting element (7).

8. Apparatus according to claim 7, wherein a further deflecting element (6) is arranged in succession to the laser radiation source (1) and the beam splitter element (2) in the optical path (3), which is configured so that it deflects the sub-beams in such a way that they run essentially parallel to one another after emerging from the further deflecting element (6).

9. Apparatus according to claim 7 or 8, wherein the deflecting element (7) is a concave lens.

10. Apparatus according to claim 8 or 9, wherein the further deflecting element (6) is a convex lens.

11. Apparatus according to any one of the claims 7 to 10, wherein the laser radiation source is a pulsed laser radiation source with pulse widths in the range from 10 nanoseconds to 10 femtoseconds.

12. Method for producing a substrate with a periodic dot structure in the micro- or submicrometer range by means of laser interference patterning, in particular for producing a patterned substrate according to any one of the claims 1 to 6, comprising the following steps:

   a) providing a substrate (5), preferably comprising a transparent material,
   b) emitting a laser beam from a laser radiation source (1),
   c) splitting the laser beam by means of a beam splitter element (2) into at least three sub-beams,
   d) focusing the sub-beams onto the surface or within the volume of the substrate (5), so that the sub-beams interfere constructively and destructively on the surface or within the volume of the substrate,
   **characterized in that** the at least three sub-beams are superimposed on the substrate by the focusing such that a periodic dot structure in the micro- or sub-micrometer range is generated on the surface or in the volume of the substrate, wherein the periodic dot structure is formed of inverse cones,
   wherein the inverse cones are arranged periodically at a distance from one another in the range from 50 nm to 50 $\mu$m,
   wherein a further structure is superimposed on the periodic dot structure,
   wherein the superimposed structure has a quasi-periodic wave structure, wherein the material on the surface of the substrate in the region of the superimposed structure has a sequence of wave crests and wave troughs, the periodicity of which is in the range of 100 nm to 1000 nm.

13. Method according to claim 12, wherein the structure period of the generated periodic dot structure of the substrate (5) is steplessly adjustable in the micro- or submicrometer range by moving the beam splitter element (2) along its optical axis in the optical path (3).

14. Method according to claim 12 or 13, wherein the substrate (5) comprises a transparent material and the sub-beams interfere inside the transparent material.

15. Method according to any one of the claims 12 to 14, comprising the following steps:

a) applying a first pulse on the surface of a substrate (5), which generates a first interference pixel on the surface of the substrate (5) or within the substrate (5),
b) applying a second pulse to the surface of a substrate (5), which generates a second interference pixel on the surface of the substrate (5) or within the substrate (5),
wherein the first and second interference pixels each independently comprise a periodic dot structure with dimensions in the micro- and submicrometer range,
**characterized in that** the offset between the second interference pixel and the first interference pixel is in the range of 10% $\leq$ x $\leq$ 50% of the interference period.

16. Method according to claim 15, wherein after step b) a third pulse is applied on the surface of a substrate (5), wherein the third interference pixel comprises a periodic dot structure with dimensions in the micro- and submicrometer range,
wherein the third pulse generates a third interference pixel on the surface of the substrate (5) or in the substrate (5), wherein the third interference pixel has an offset in the range of 10% $\leq$ x $\leq$ 50% of the interference period with respect to the second interference pixel.

17. Method according to claim 15, wherein the offset of the interference period is uniform in at least one spatial direction.

18. Use of the patterned substrate according to claim 1 in photovoltaic systems.

19. Use of the patterned substrate according to any one of the claims 1 to 6 as anti-reflective glazing of monitors, screens and displays.

20. Use of the patterned substrate according to any one of the claims 1 to 6 in glass fibers.

21. Use of the patterned substrate according to any one of the claims 1 to 6 as a negative mold for indirectly applying or creating patterns on another substrate.

**Revendications**

1. Substrat structuré (5) à propriétés antireflet, comprenant une structure ponctuelle périodique de taille de l'ordre du micromètre ou inférieure au micromètre,

la structure ponctuelle périodique étant formée de cônes inversés,
les cônes étant agencés périodiquement avec un espacement de l'ordre de 50 nm à 50 $\mu$m,
une autre structure étant superposée à la structure ponctuelle périodique,
la structure superposée présentant une structure ondulatoire quasi-périodique, le matériau présent sur la surface du substrat dans la zone de la structure superposée présentant une séquence de crêtes et de creux d'onde dont la périodicité est de l'ordre de 100 nm à 1000 nm.

2. Substrat structuré selon la revendication 1, dans lequel la structure ponctuelle périodique est conçue de telle sorte que le substrat structuré transmet le rayonnement électromagnétique à une longueur d'onde de plus de 550 nm, de préférence de plus de 500 nm, et tout particulièrement de plus de 450 nm.

3. Substrat structuré selon la revendication 1 ou 2, comprenant une structure ponctuelle périodique de taille de l'ordre du micromètre ou inférieure au micromètre, une structure ondulatoire périodique étant superposée à la structure ponctuelle périodique, les crêtes d'onde étant agencées avec un espacement de l'ordre de 20 nm à 5 $\mu$m.

4. Substrat structuré selon l'une quelconque des revendications 1 à 3, dans lequel le substrat structuré comprend une structure ponctuelle formée d'un premier et d'un second pixel d'interférence, le premier et le second pixel d'interférence comprenant respectivement, indépendamment l'un de l'autre, une structure ponctuelle périodique ayant des dimensions de l'ordre du micromètre et/ou inférieures au micromètre, le premier pixel d'interférence et le second pixel d'interférence étant superposés l'un à l'autre de manière à ce que le décalage entre le second pixel d'interférence et le premier pixel d'interférence soit de l'ordre de 10 % $\leq$ x $\leq$ 50 % de la période d'interférence.

**5.** Substrat structuré selon l'une quelconque des revendications 1 à 4, dans lequel le substrat structuré comprend un matériau transparent, et dans lequel le matériau transparent est sélectionné dans le groupe comprenant le verre, des polymères solides, des céramiques transparentes ou leurs mélanges.

**6.** Substrat structuré selon l'une quelconque des revendications 1 à 5, dans lequel l'indice de réfraction du substrat structuré est progressif.

**7.** Dispositif de structuration par interférence laser pour la structuration directe par interférence laser d'un substrat afin de produire un substrat structuré selon l'une quelconque des revendications 1 à 6, comprenant

- une source de rayonnement laser (1) pour émettre un faisceau laser,
- un élément diviseur de faisceau (2) agencé dans le chemin du faisceau (3) du faisceau laser,
- un élément de focalisation (4) agencé en aval de l'élément diviseur de faisceau (2) dans le chemin du faisceau (3) du laser et conçu de telle sorte que les faisceaux partiels le traversent de manière à pouvoir interférer sur la surface ou dans le volume d'un substrat (5) dans une zone d'interférence,

**caractérisé en ce que**

le diviseur de faisceau (2) est librement mobile le long de son axe optique dans le chemin du faisceau (3),
le diviseur de faisceau (2) est conçu pour diviser le faisceau laser incident, émis par la source de rayonnement laser (1), en au moins trois faisceaux partiels,
un premier élément de déviation (7) est agencé en aval de l'élément diviseur de faisceau (2) dans le chemin du faisceau (3) de la source de rayonnement laser (1), et est conçu de telle sorte que lesdits au moins trois faisceaux partiels soient élargis lors de leur passage à travers l'élément de déviation (7).

**8.** Dispositif selon la revendication 7, dans lequel un autre élément de déviation (6) est agencé dans le chemin du faisceau (3) de la source de rayonnement laser (1), en aval de la source de rayonnement laser (1) et de l'élément diviseur de faisceau (2), et est conçu de telle sorte qu'il dévie les faisceaux partiels de manière à ce qu'ils soient sensiblement parallèles les uns aux autres après leur sortie de l'autre élément de déviation (6).

**9.** Dispositif selon l'une quelconque des revendications 7 ou 8, dans lequel le premier élément de déviation (7) est une lentille concave.

**10.** Dispositif selon l'une quelconque des revendications 8 ou 9, dans lequel l'autre élément de déviation (6) est une lentille convexe.

**11.** Dispositif selon l'une quelconque des revendications 7 à 10, dans lequel la source de rayonnement laser est une source de rayonnement laser pulsée présentant des largeurs d'impulsion de l'ordre de 10 nanosecondes à 10 femtosecondes.

**12.** Procédé de fabrication d'un substrat présentant une structure ponctuelle périodique de taille de l'ordre du micromètre ou inférieure au micromètre au moyen de la structuration par interférence laser, notamment pour la production d'un substrat structuré selon l'une quelconque des revendications 1 à 6, comprenant les étapes suivantes

a) fournir un substrat (5), comprenant de préférence un matériau transparent,
b) émettre un faisceau laser à partir d'une source de rayonnement laser (1),
c) diviser le faisceau laser en au moins trois faisceaux partiels au moyen d'un élément diviseur de faisceau (2),
d) focaliser les faisceaux partiels sur la surface ou à l'intérieur du volume du substrat (5), de sorte que les faisceaux partiels interfèrent de manière constructive et destructive sur la surface ou à l'intérieur du volume du substrat,
**caractérisé en ce que** lesdits au moins trois faisceaux partiels sont superposés sur le substrat par focalisation de manière à générer une structure ponctuelle périodique de taille de l'ordre du micromètre ou inférieure au micromètre sur la surface ou dans le volume du substrat, la structure ponctuelle périodique étant formée de cônes inversés,
les cônes étant agencés périodiquement avec un espacement de l'ordre de 50 nm à 50 $\mu$m, une autre structure étant superposée à la structure ponctuelle périodique,
la structure superposée présentant une structure ondulatoire quasi-périodique, le matériau présent sur la surface du substrat dans la zone de la structure superposée présentant une séquence de crêtes et de creux d'onde dont la périodicité est de l'ordre de 100 nm à 1000 nm.

**13.** Procédé selon la revendication 12, dans lequel la période de structure de la structure ponctuelle périodique générée sur le substrat (5) de taille de l'ordre du micromètre ou inférieure au micromètre est réglable en continu en déplaçant l'élément diviseur de faisceau (2) le long de son axe optique dans le chemin du faisceau (3).

**14.** Procédé selon la revendication 12 ou 13, dans lequel le substrat (5) comprend un matériau transparent et les faisceaux partiels interfèrent à l'intérieur du matériau transparent.

**15.** Procédé selon l'une quelconque des revendications 12 à 14, comprenant les étapes suivantes :

a) appliquer une première impulsion sur la surface d'un substrat (5), laquelle génère un premier pixel d'interférence sur la surface du substrat (5) ou dans le substrat (5),
b) appliquer une deuxième impulsion sur la surface d'un substrat (5), laquelle génère un deuxième pixel d'interférence sur la surface du substrat (5) ou dans le substrat (5),
le premier et le deuxième pixel d'interférence comprenant respectivement, et indépendamment l'un de l'autre, une structure ponctuelle périodique ayant des dimensions de l'ordre du micromètre ou inférieures au micromètre, **caractérisé en ce que** le décalage entre le deuxième pixel d'interférence et le premier pixel d'interférence est de l'ordre de 10 % $\leq$ x $\leq$ 50 % de la période d'interférence.

**16.** Procédé selon la revendication 15, dans lequel, après l'étape b), une troisième impulsion est appliquée sur la surface d'un substrat (5), le troisième pixel d'interférence comprenant une structure ponctuelle périodique ayant des dimensions de l'ordre du micromètre ou inférieures au micromètre, la troisième impulsion générant un troisième pixel d'interférence sur la surface du substrat (5) ou dans le substrat (5), le troisième pixel d'interférence présentant un décalage par rapport au deuxième pixel d'interférence de l'ordre de 10 % $\leq$ x $\leq$ 50 % de la période d'interférence.

**17.** Procédé selon la revendication 15, dans lequel le décalage de la période d'interférence est uniforme dans au moins une direction spatiale.

**18.** Utilisation du substrat structuré selon l'une quelconque des revendications 1 à 6 dans des installations photovoltaïques.

**19.** Utilisation du substrat structuré selon l'une quelconque des revendications 1 à 6 comme vitrage antireflet pour des moniteurs, des écrans et des afficheurs.

**20.** Utilisation du substrat structuré selon l'une quelconque des revendications 1 à 6 dans des fibres optiques.

**21.** Utilisation du substrat structuré selon l'une quelconque des revendications 1 à 6 en tant que forme négative pour l'application ou la production indirecte de structures sur un autre substrat.

**Fig. 1**

**Fig. 2**

**Fig. 3**

Fig. 4A

Fig. 4B

**Fig. 5A**

**Fig. 5B**

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8557877 B2
- US 10459125 B2
- WO 2019166836 A1
- EP 2431120 A1
- US 20040227927 A1
- US 2001035991 A1
- EP 2596899 B1
- EP 2663892 A
- DE 102010005774 A1

**In der Beschreibung aufgeführte Nicht-Patentliteratur**

- **SOLDERA et al.** Soda Lime Glass through Direct Laser Interference Patterning. *Nanomaterials*, 2021
- **EI-KHOURY et al.** Improving throughput and microstructure uniformity in Direct Laser Interference Patterning utilizing top-hat shaped beams. *Research Square*, 2021
- **BOUCHARD et al.** Hierarchical Microtextures Embossed on PET from Laser-Patterned Stamps. *Materials*, 2021